(19) Europäisches Patentamt
European Patent Office
Office européen des brevets

(11) EP 2 023 203 B1

(12) **EUROPEAN PATENT SPECIFICATION**

(45) Date of publication and mention of the grant of the patent:
**20.10.2010 Bulletin 2010/42**

(51) Int Cl.:
***G03F 7/033*** *(2006.01)* ***G03F 7/038*** *(2006.01)*

(21) Application number: **08013249.1**

(22) Date of filing: **23.07.2008**

(54) **Photosensitive composition, photosensitive resin transfer film, and method for producing a photospacer, and substrate for a liquid crystal display device and liquid crystal display device**

Lichtempfindliche Zusammensetzung, lichtempfindlicher Harzübertragungsfilm, sowie Verfahren zur Herstellung eines Lichtabstandhalters und Substrat für eine Flüssigkristallanzeigenvorrichtung und Flüssigkristallanzeige

Composition photosensible, film de transfert de résine photosensible, et procédé de production de photo-espaceur, et substrat pour dispositif d'affichage à cristaux liquides et dispositif d'affichage à cristaux liquides

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **26.07.2007 JP 2007194239**

(43) Date of publication of application:
**11.02.2009 Bulletin 2009/07**

(73) Proprietor: **FUJIFILM Corporation**
**Minato-ku**
**Tokyo (JP)**

(72) Inventors:
- **Nakamura, Hideyuki**
  **Shizuoka-ken (JP)**
- **Mochizuki, Kyohei**
  **Shizuoka-ken (JP)**
- **Fukushige, Yuuichi**
  **Shizuoka-ken (JP)**
- **Arioka, Daisuke**
  **Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A- 1 505 441**
**EP-A- 1 564 591**
**EP-A- 1 975 709**
**WO-A-2008/123601**
**DE-A1- 10 206 364**
**JP-A- 2002 287 354**
**JP-A- 2003 207 787**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 023 203 B1

## Description

BACKGROUND OF THE INVENTION

Field of Invention

The present invention relates to a photosensitive composition and a photosensitive resin transfer film which are suitable for producing a spacer which may be used for a display device, in which fluctuations in the cell thickness of a liquid crystal cell tend to cause display unevenness, and to a method for producing a photospacer. The present invention also relates to a substrate for a liquid crystal display device (a liquid crystal display device substrate) and a liquid crystal display device each having the photospacer produced by this method.

Description of the Related Art

Hitherto, liquid crystal display devices have widely been used in display apparatuses for displaying high-quality images. In liquid crystal display devices, a liquid crystal layer capable of displaying images is generally arranged between a pair of substrates in accordance with a predetermined orientation. Maintenance of a uniform distance between the substrates, that is, maintaining a uniform thickness of the liquid crystal layer, is one factor determining image quality. For this purpose, spacers are disposed in order to keep the thickness of the liquid crystal layer uniform. The distance between the substrates is generally called the "cell thickness". The cell thickness usually represents the thickness of the liquid crystal layer, that is, the distance between two electrodes for applying an electric field to the liquid crystal in a display region.

Hitherto, the spacers have been formed by scattering beads. In recent years, however, spacers have been formed with high positional precision by photolithography using a photosensitive composition. Such a spacer, which is formed by use of a photosensitive composition, is called a photospacer.

Photospacers formed by subjecting a photosensitive composition to patterning, alkali development and baking have tendencies toward weak compression strength of spacer dots thereof and toward large plastic deformation when a panel is formed. In order to display high quality images, it is required that problems caused by these tendencies are avoided, namely, problems whereby the uniformity of a liquid crystal layer cannot be maintained due to a smaller thickness of the liquid crystal layer than the designed value thereof, image unevenness is generated, or the like. From the viewpoint of improving the definition of liquid crystal display devices, it is also important that an alkali-development-residue of the photosensitive composition (i.e., a residue of the photosensitive composition after alkali development) is not generated.

In connection with the above, use of a resin having an allyl group for forming a spacer has been disclosed as a spacer-forming technique for keeping the thickness of a liquid crystal layer (cell thickness) uniform (see, for example, Japanese Patent Application Laid-Open (JP-A) No. 2003-207787).

Further, a photosensitive composition for photospacers which is easily produced and is excellent in storage stability has been disclosed (see, for example, JP-A No. 2005-62620).

Furthermore, a composition excellent in hot and cold shock resistance has also been disclosed (see, for example, JP-A No. 2002-287354).

SUMMARY OF THE INVENTION

Photospacers used in liquid crystal cells are intrinsically required to have a high deformation restorability. The deformation restorability may be improved to some degree by increasing the crosslinking reaction rate of a monomer. However, the effects of this improvement tend to peak and level off and, therefore, further improvement is demanded.

In view of the above situation, an object of the present invention is to provide a photosensitive composition which has high deformation restorability and may eliminate display unevenness in a liquid crystal display device, a photosensitive resin transfer film, and a method for producing a photospacer by using the composition or the film. Another object of the present invention is to provide a substrate for a liquid crystal display device and a liquid crystal display device which may eliminate display unevenness and display high quality images.

The inventors of the present invention have found that, when a resin is used that includes a group having a cyclic structure including two or more heteroatoms in a side chain as defined below, a group having an acidic group in a side chain, and a group having an ethylenically unsaturated group in a side chain, deformation restorability is remarkably improved and that such a resin is particularly effective in eliminating display unevenness.

According to an aspect of the present invention, a photosensitive composition is provided, which comprises:

a resin (A) including a group having a cyclic structure including two or more heteroatoms in a side chain as defined below, a group having an acidic group in a side chain, and a group having an ethylenically unsaturated group in a

side chain;
a polymerizable compound (B); and
a photopolymerization initiator (C).

According to another aspect of the present invention, there is provided a photosensitive resin transfer film, comprising:

a pre-support; and
a photosensitive resin layer provided on the pre-support,

wherein the photosensitive resin layer is formed using the photosensitive composition.

According to another aspect of the present invention, there is provided a method for producing a photospacer, comprising applying the photosensitive composition to form a photosensitive resin layer on a support.

According to another aspect of the invention, there is provided a method for producing a photospacer, comprising transferring the photosensitive resin transfer film by means of at least one of heating and pressing to form a photosensitive resin layer on a support.

According to another aspect of the invention, there is provided a substrate for a liquid crystal display device, comprising a photospacer produced by the method for producing a photospacer.

According to another aspect of the invention, there is provided a liquid crystal display device, comprising the substrate for a liquid crystal display device.

The invention may provide: a photosensitive composition which has a high deformation restorability and may eliminate display unevenness in a liquid crystal display device, a photosensitive resin transfer film and a method for producing a photospacer by using the composition or the film; and a liquid crystal display device substrate and a liquid crystal display device which may eliminate display unevenness and thus display high quality images.

## DETAILED DESCRIPTION OF THE INVENTION

The photosensitive composition, the method for producing a photospacer, the liquid crystal display device substrate, and the liquid crystal display device of the invention will be described in detail hereinafter.

### Photosensitive Composition and Method for Producing a Photospacer

The photosensitive composition of the invention at least includes: (A) a resin having a group having a cyclic structure including two or more heteroatoms in a side chain, a group having an acidic group in a side chain, and a group having an ethylenically unsaturated group in a side chain, (B) a polymerizable compound, and (C) a photopolymerization initiator. A photospacer produced by using the photosensitive composition of the present invention has high deformation restorability and thus may eliminate display unevenness in a display device.

For example, the method of the invention for producing a photospacer is a method for producing the photospacer in a liquid crystal display device at least having at least two supports, a liquid crystal arranged between the supports, two electrodes that apply an electric field to the liquid crystal, and a photospacer for regulating the cell thickness between the supports, the method having a layer forming process of forming a photosensitive resin layer including the photosensitive composition of the invention on one of the two supports.

According to the method of producing a photospacer of the invention, a photospacer having a high deformation restorability may easily be produced.

The method of producing a photospacer (i.e., a photospacer producing method) of the invention will be described hereinafter. Through the description, the photosensitive composition of the invention will also be described in detail.

### Layer forming process

The layer forming process in the invention is a process of forming, on a support, a photosensitive resin layer including the photosensitive composition of the invention, which may be referred to merely as a "photosensitive resin composition layer" hereinafter.

The photosensitive resin layer is subjected to a production process that will be detailed later, to thereby form a photospacer which has superior deformation restorability and may keep the cell thickness uniform. By use of the photospacer, display unevenness in images is effectively prevented in particular in display devices wherein display unevenness is easily caused by a fluctuation in the cell thickness.

Examples of the method for forming the photosensitive resin layer on a support include (a) a method of applying a solution including the photosensitive composition of the invention by a known coating method, and (b) a method of

laminating a photosensitive resin transfer film by a transfer method. Each of the methods will be described in detail hereinafter.

(a) Application method

The photosensitive composition may be applied by a known method such as spin coating, curtain coating, slit coating, dip coating, air knife coating, roller coating, wire bar coating, gravure coating, or extrusion coating using a hopper described in US Patent No. 2681294. Particularly preferable examples include methods using a slit nozzle or slit coater, which are described in JP-A Nos. 2004-89851, 2004-17043, 2003-170098, 2003-164787, 2003-10767, 2002-79163, 2001-310147 and so on.

(b) Transfer method

In the case of the transferring method, a photosensitive resin transfer film is used. A photosensitive resin layer formed in a film form on a pre-support is adhered onto a surface of a support by compression or heating compression using a heated and/or pressured roller or flat plate. Thereafter, the pre-support is peeled off to transfer the photosensitive resin composition layer onto the support. Specific examples of the method or a device for the method include laminators and lamination methods described in JP-A Nos. 7-110575, 11-77942, 2000-334836, and 2002-148794. The method described in JP-ANo. 7-110575 is preferably used from the viewpoint of less foreign substances.

When the photosensitive resin layer is formed, an oxygen blocking layer, which may be referred to as an "oxygen blocking film" or "intermediate layer" hereinafter, may be arranged between the photosensitive resin layer and the pre-support. In this way, the sensitivity of exposure to light may be increased. In order to improve the transferability, a thermoplastic resin layer having cushion property may additionally be provided.

Examples of the pre-support, the oxygen blocking layer, the thermoplastic resin layer and other layers which constitute the photosensitive transfer film, and the method for forming the photosensitive transfer film include constitutions and a formation method described in paragraphs [0024] to [0030] of JP-A No. 2006-23696.

When forming the photosensitive resin layer by (a) the application method or (b) the transfer method, the layer thickness of the photosensitive resin layer is preferably from 0.5 to 10.0 μm, and more preferably from 1 to 6 μm. When the layer thickness is within this range, generation of pinholes during the formation of the photosensitive resin layer is prevented, and development and removal of the layer in unexposed regions do not take a long period of time.

Examples of the support on which the photosensitive resin layer is to be formed include transparent substrates (such as a glass substrate or a plastic substrate); substrates provided with a transparent electroconductive film (such as an ITO film); substrates provided with a color filter, which are also called color filter substrates; and substrates provided with a driving element (such as a thin film transistor (TFT)). In general, the thickness of the support is preferably from 700 to 1,200 μm.

Photosensitive Composition

Next, the photosensitive composition will be described.

The photosensitive composition includes at least: (A) a resin including a group having a cyclic structure including two or more heteroatoms in a side chain, a group having an acidic group in a side chain, and a group having an ethylenically unsaturated group in a side chain, which may be referred to merely as the "resin A" hereinafter; (B) a polymerizable compound; and (C) a photopolymerization initiator. If necessary, the composition may include other components such as a colorant or a surfactant.

The photosensitive composition is particularly preferably used for a photospacer.

Resin (A)

The resin (A) includes a group having a cyclic structure including two or more heteroatoms in a side chain: X, a group having an acidic group in a side chain: Y, and a group having an ethylenically unsaturated group in a side chain: Z. If necessary, the resin (A) may include at least one other additional group: (L) (1% by mole). One of the groups in the resin (A) may be a combination of the groups X, Y and Z.

Group having a cyclic structure including two or more heteroatoms in a side chain: X

The "group having a cyclic structure including two or more heteroatoms in a side chain" will be described hereinafter.

The "group having a cyclic structure including two or more heteroatoms in a side chain" has a structure represented by the following Formula (a).

Formula (a)

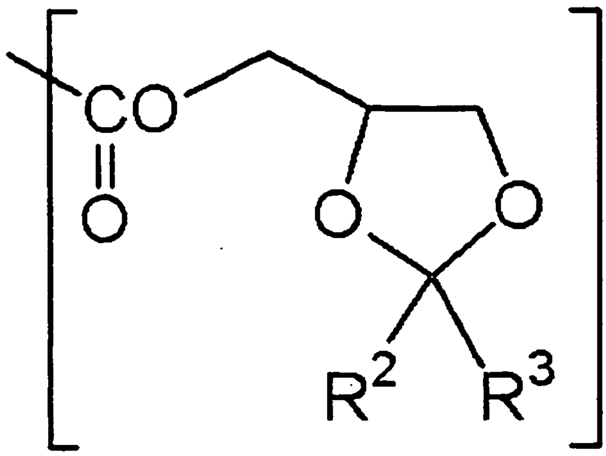

In Formula (a), $R^2$ and $R^3$ each independently represent a hydrogen atom, a methyl group, an ethyl group, an n-propyl group, an n-butyl group, or a branched alkyl group having 3 to 12 carbon atoms; and $R^2$ and $R^3$ may be bonded to each other to form a ring.

Examples of the branched alkyl group having 3 to 12 carbon atoms include i-propyl, i-butyl, s-butyl, t-butyl, isopentyl, neopentyl, 2-methylbutyl, isohexyl, 2-ethylhexyl, 2-methylhexyl, i-amyl, t-amyl, 3-octyl, and t-octyl groups. Of the groups, preferred are i-propyl, i-butyl, s-butyl, t-butyl, isopentyl and other groups. More preferred are i-propyl, i-butyl, s-butyl, t-butyl and other groups.

In Formula (a), particularly preferred examples of $R^2$ and $R^3$ include methyl, ethyl, i-propyl, i-butyl, s-butyl and t-butyl groups, and groups which are bonded to each other to form a 6-membered ring.

The "group having a cyclic structure including two or more heteroatoms in a side chain" may have at least one of the following structures and a structure represented by Formula (a). In the structures, $R^a$ is a hydrogen atom or a methyl group.

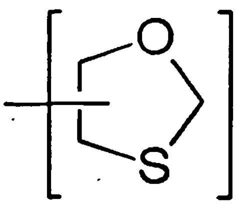

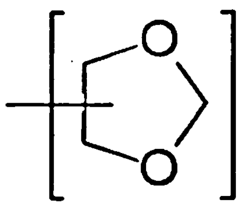

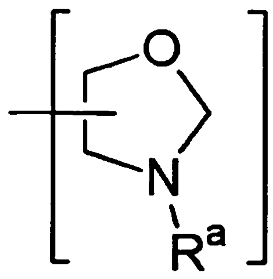

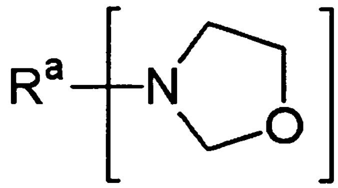
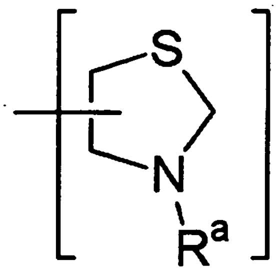
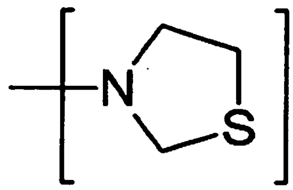

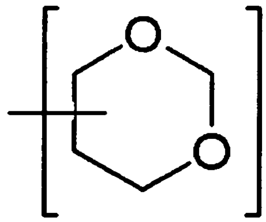
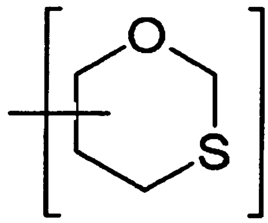
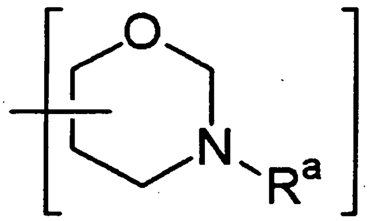

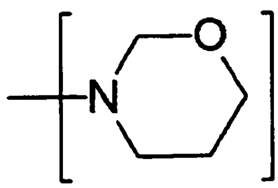
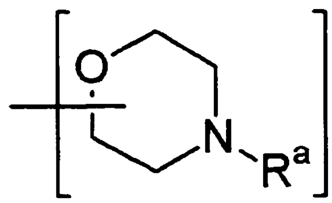
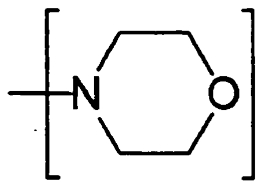

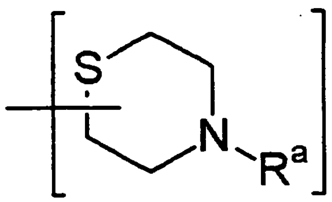
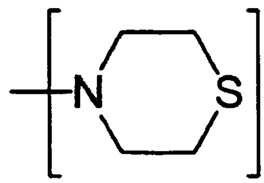
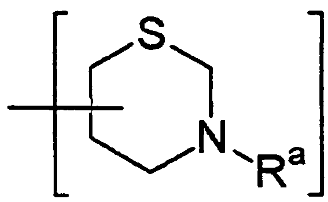

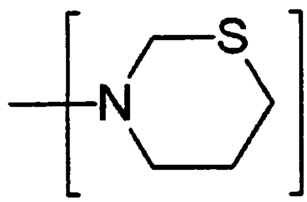
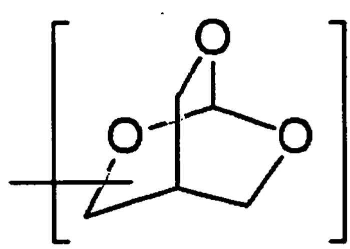

The "group having a cyclic structure including two or more heteroatoms in a side chain" may be introduced into the resin (A) by using a monomer having a cyclic structure including two or more heteroatoms in a side chain.

The "monomer having a cyclic structure including two or more heteroatoms in a side chain" is preferably a monomer represented by the following Formula (b). The structure represented by Formula (a) may be introduced into the resin (A) by using the monomer represented by Formula (b).

Formula (b)

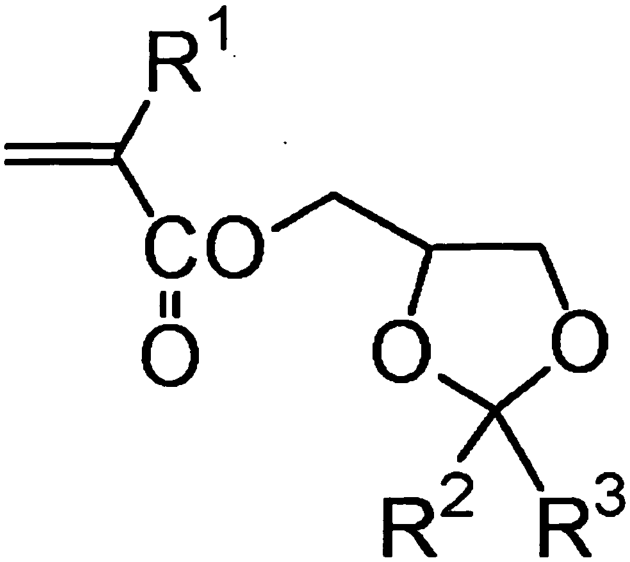

In Formula (b), $R^1$ represents a hydrogen atom or a methyl group.

In Formula (b), $R^2$ and $R^3$ have the same meanings as $R^2$ and $R^3$ in Formula (a). Preferred examples thereof are also the same.

Specific examples of the monomer represented by Formula (b) are shown below. However, the monomer represented by Formula (b) is not limited to these examples.

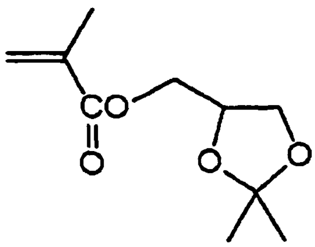

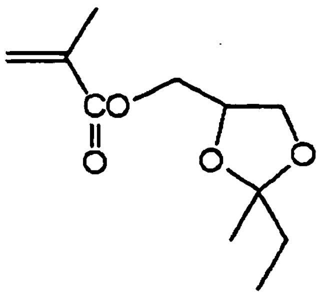

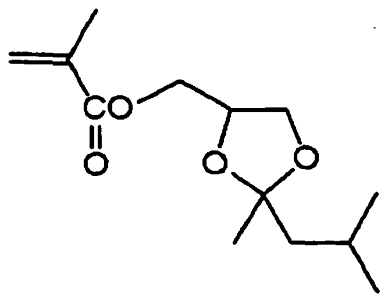

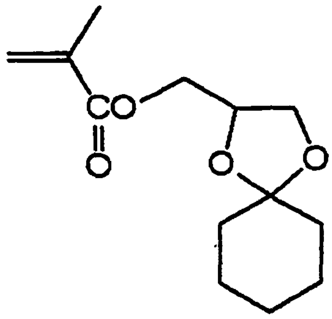
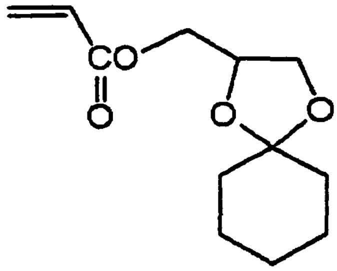
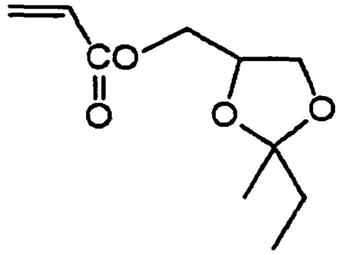

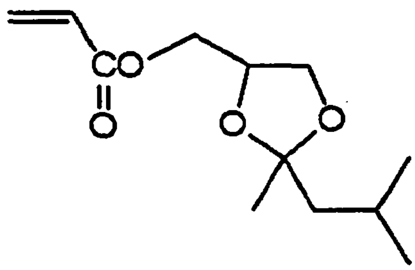

Group having an acidic group in a side chain: Y

The acidic group is not particularly limited, and may be appropriately selected from known acidic groups. Examples of the acidic group include carboxyl, sulfonic acid, sulfonamide, phosphoric acid, and phenolic hydroxyl groups. Of the groups, carboxyl and phenolic hydroxyl groups are preferred from the viewpoints of excellent developability and imparting excellent water resistance to a cured film.

A monomer for introducing the "group having an acidic group in a side chain" into the resin (A) is not particularly limited, and examples thereof include styrenes, (meth)acrylates, vinyl ethers, vinyl esters, and (meth)acrylamides. Of those, (meth)acrylates, vinyl esters, and (meth)acrylamides are preferred, and (meth)acrylates are more preferred.

The monomer for introducing the "group having an acidic group in a side chain" into the resin (A) may be appropriately selected from known monomers, and specific examples thereof include (meth)acrylic acid, vinyl benzoate, maleic acid, monoalkyl maleate, fumaric acid, itaconic acid, crotonic acid, cinnamic acid, sorbic acid, α-cyanocinnamic acid, an acrylic acid dimer, an addition reaction product made from a monomer having a hydroxyl group and a cyclic acid anhydride, and ω-carboxy-polycaprolactone mono(meth)acrylate. As these compounds, appropriately produced compounds may be used, or commercially available products may be used.

Regarding the addition reaction product, which is made from a monomer having a hydroxyl group and a cyclic acid anhydride, an example of the monomer having a hydroxyl group is 2-hydroxyethyl (meth)acrylate, and examples of the cyclic acid anhydride include maleic anhydride, phthalic anhydride, and cyclohexanedicarboxylic acid anhydride.

Examples of a commercially available product of the "group having an acidic group in a side chain" include: ARONIX M-5300, ARONIX M-5400, ARONIX M-5500, and ARONIX M-5600 (trade names, all manufactured by Toagosei Co., Ltd.); NK ESTER CB-1, and NK ESTER CBX-1 (trade names, all manufactured by Shin-Nakamura Chemical Co., Ltd.); HOA-MP and HOA-MS (trade names, all manufactured by Kyoeisha Yushi Kagaku Kogyo Co., Ltd.); and VISCOAT #2100 (trade name, manufactured by Osaka Organic Chemical Industry Ltd). Of these, (meth)acrylic acid is preferred from the viewpoints of excellent developability and low costs.

Group having an ethylenically unsaturated group in a side chain: Z

The "group having an ethylenically unsaturated group in a side chain" is not particularly limited, and the ethylenically unsaturated group is preferably a (meth)acryloyl group. The ethylenically unsaturated group and a monomer are not particularly limited as long as they are linked to each other through a bivalent linking group such as an ester group, an amide group, or a carbamoyl group. The method for introducing the ethylenically unsaturated group into the side chain of a group may be appropriately selected from known methods. Examples of the method include: methods

of adding a (meth)acrylate having an epoxy group to a group having an acidic group; methods of adding a (meth)acrylate having an isocyanate group to a group having a hydroxyl group; and methods of adding a (meth)acrylate having a hydroxyl group to a group having an isocyanate group.

Of the methods, preferred is a method of adding a (meth)acrylate having an epoxy group to a recurring unit having an acidic group since the method is the simplest production method, and is low in costs.

The (meth)acrylate having an epoxy group is not particularly limited, and preferred examples thereof include a compound represented by the following Structural Formula (1) and a compound represented by the following Structural Formula (2).

Structural Formula (1)

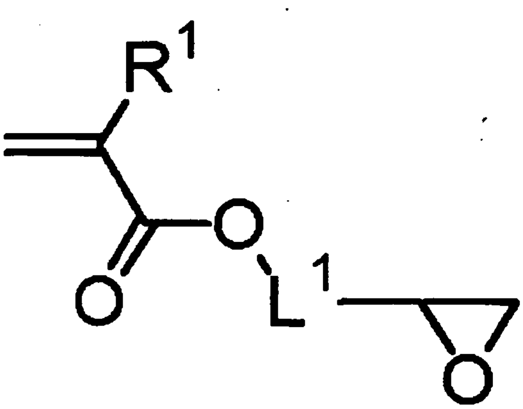

In Structural Formula (1), $R^1$ represents a hydrogen atom or a methyl group, and $L^1$ represents an organic group.

Structural Formula (2)

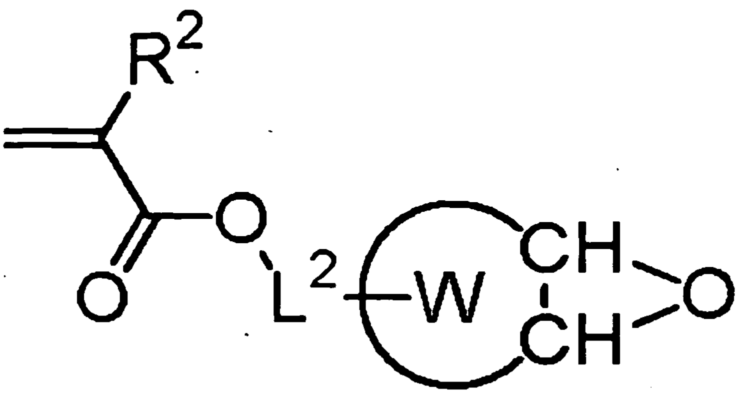

In Structural Formula (2), $R^2$ represents a hydrogen atom or a methyl group, $L^2$ represents an organic group, and W represents a 4- to 7-membered aliphatic hydrocarbon group.

Of the compound represented by Structural Formula (1) and the compound represented by Structural Formula (2), the compound represented by Structural Formula (1) is more preferred than that represented by Structural Formula (2). In Structural Formulae (1) and (2), $L^1$ and $L^2$ are each independently preferably an alkylene group having 1 to 4 carbon atoms.

The compound represented by Structural Formula (1) or (2) is not particularly limited, and examples thereof include the following exemplified compounds (1) to (10).

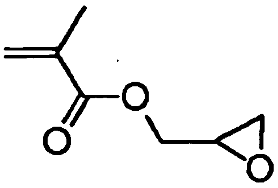
(1)

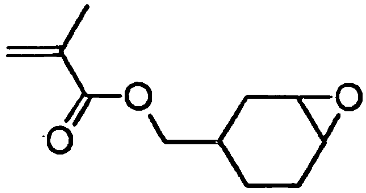
(6)

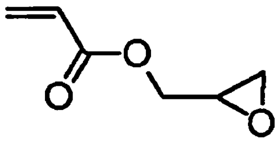
(2)

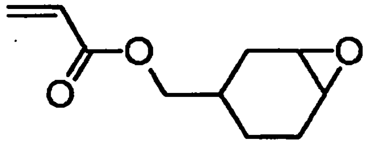
(7)

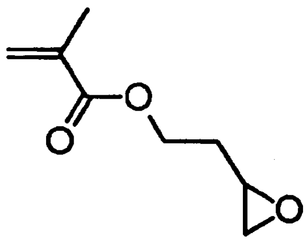
(3)

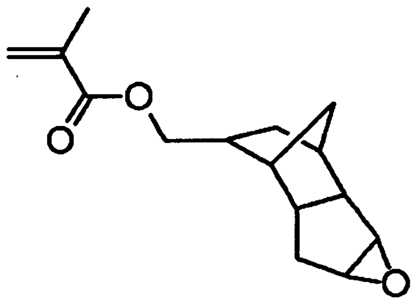
(8)

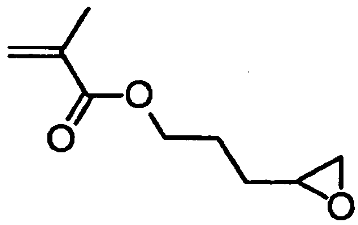
(4)

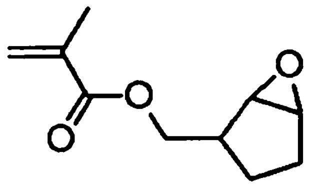
(9)

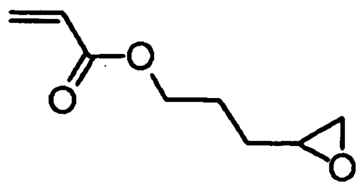
(5)

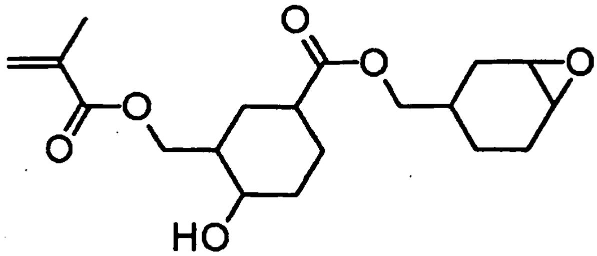
(10)

Additional monomer

For the resin (A) in the invention, an additional monomer may be used to introduce an additional group (L) into the resin.

The additional monomer is not particularly limited, and examples thereof include (meth)acrylic acid ester, styrene, and a monomer having a vinyl ether group, a bibasic acid anhydride group, a vinyl ester group, a hydrocarbon alkenyl group or the like.

The vinyl ether group is not particularly limited, and is, for example, a butyl vinyl ether group.

The bibasic acid anhydride group is not particularly limited, and is, for example, a maleic anhydride group, or an itaconic anhydride group.

The vinyl ester group is not particularly limited, and is, for example, a vinyl acetate group.

The hydrocarbon alkenyl group is not particularly limited, and is, for example, a butadiene group, or an isoprene group.

The content ratio of the additional monomer in the resin (A) may be from 0 to 30% by mole, or more preferably from 0 to 20% by mole in molar ratio.

Specific examples of the resin (A) include compounds represented by the following Compound Structures P-1 to P-4, P-11 to P-13, P-17 to P-20, P-22 and P-23, which may be referred to as "Exemplified Compounds P-1 to P-4, P-11 to P-13, P-17 to P-20, P-22 and P-23.

Compounds P-5 to P-10, P-14 to P-16, and P-21 do not fall under the scope of claim 1 and are cited just for reference purposes.

In Compounds P-1 to P-23, $R^X$, $R^Y$, $R^Z$ and $R^L$ each independently represent a hydrogen atom, or a methyl group. In Compounds P-1 to P-23, x, y, z, and 1 each represent a polymerization composition ratio (molar ratio) and, in a favorable embodiment, are within the preferred ranges described below. The weight-average molecular weight of each of Compounds P-1 to P-23 is also within the preferable range described below in a favorable embodiment.

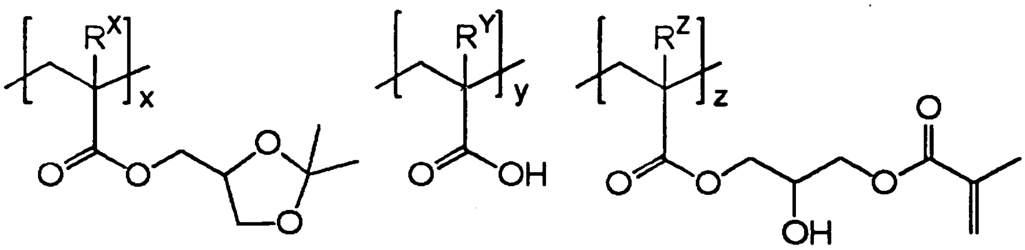

P-1

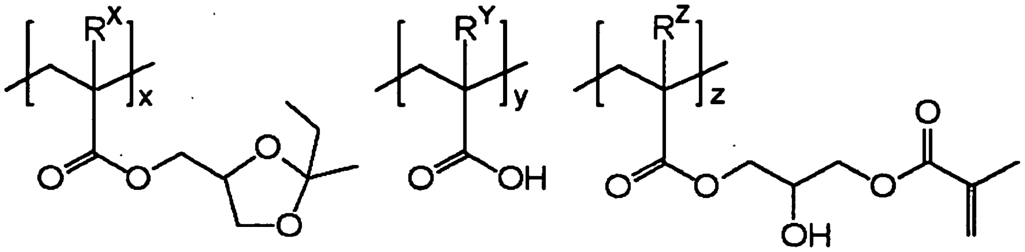

P-2

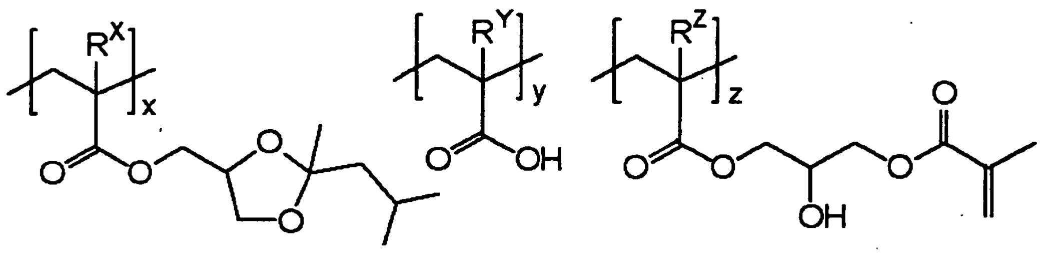

P-3

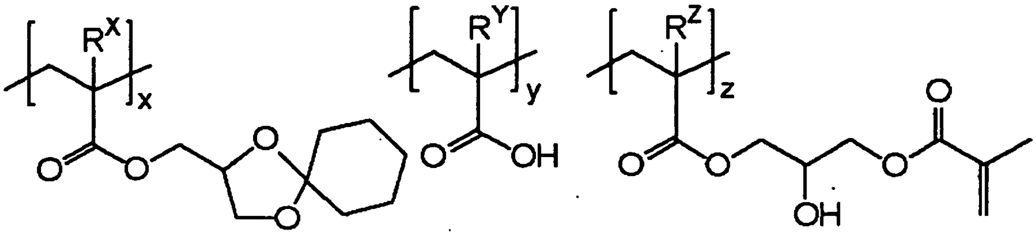

P-4

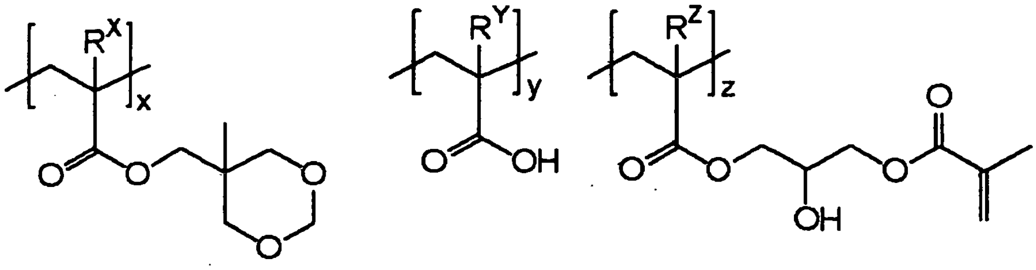

P-5

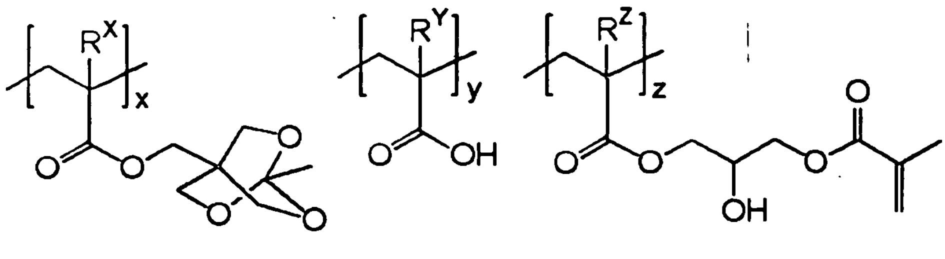

P-6

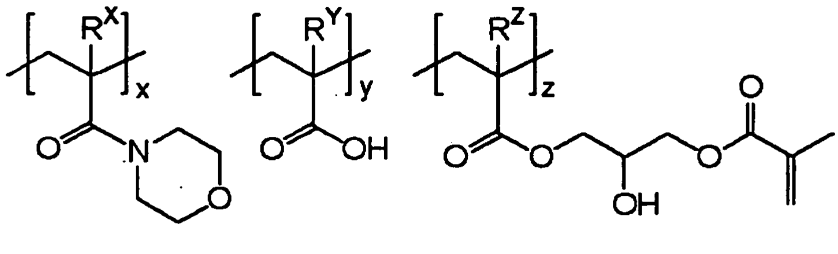

P-7

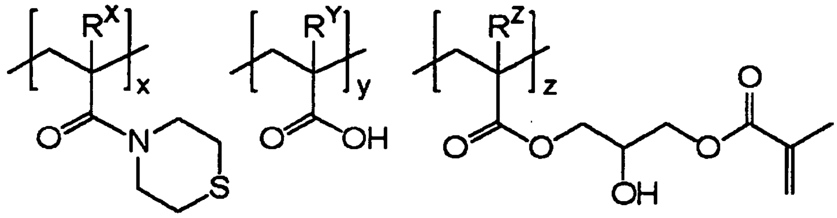

P-8

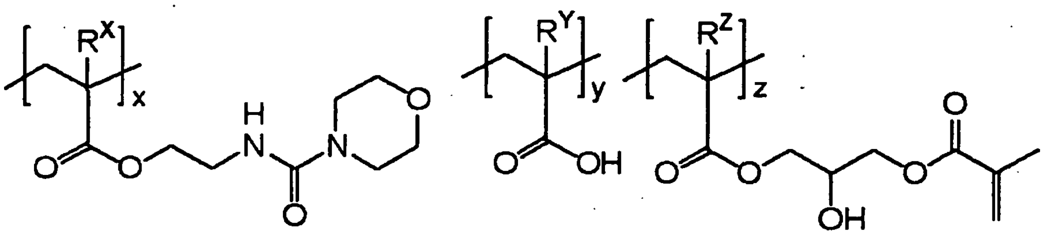

P-9

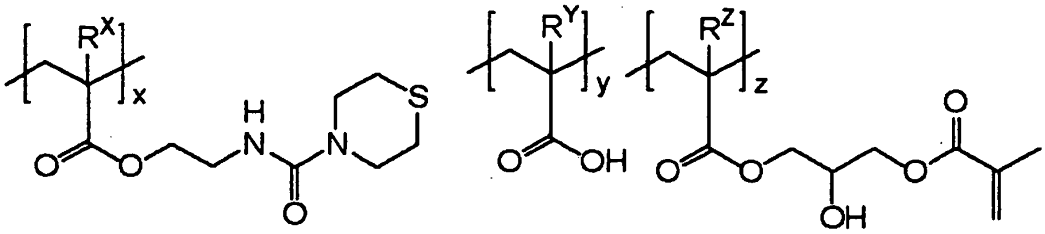

P-10

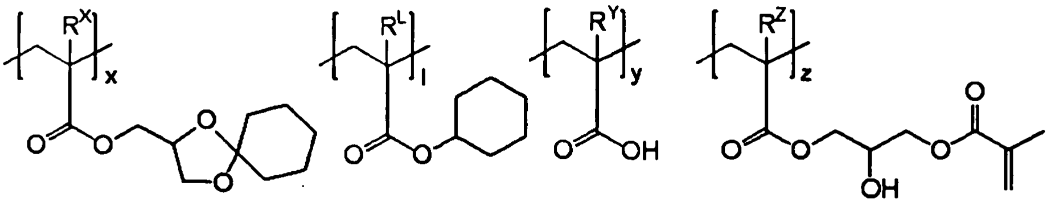

P-11

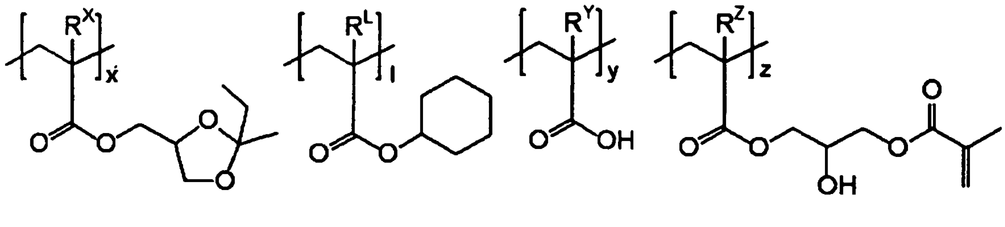

P-12

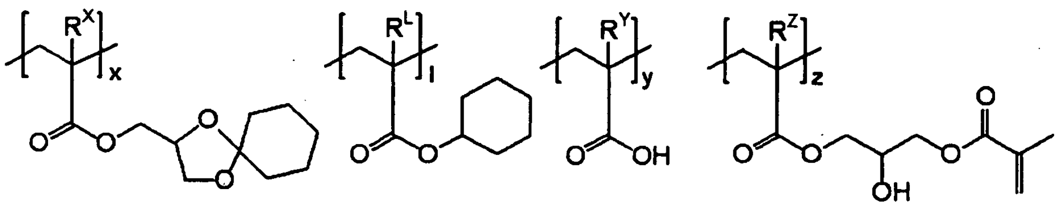

P-13

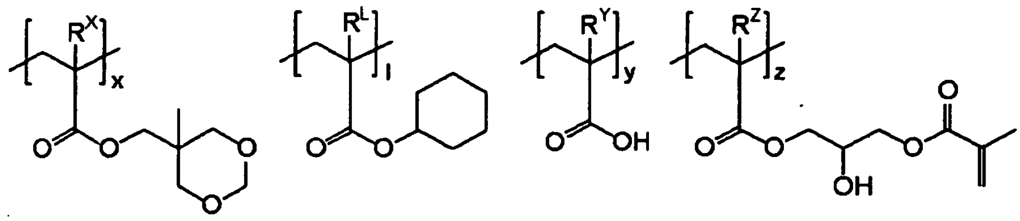

P-14

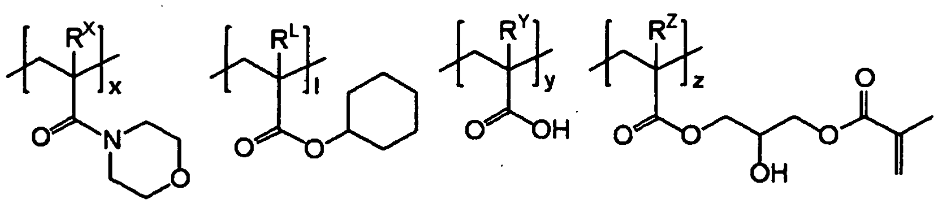

P-15

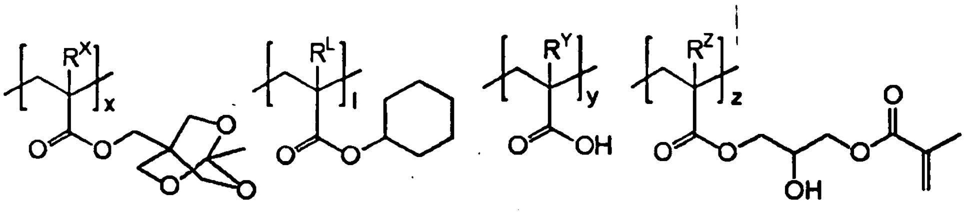

P-16

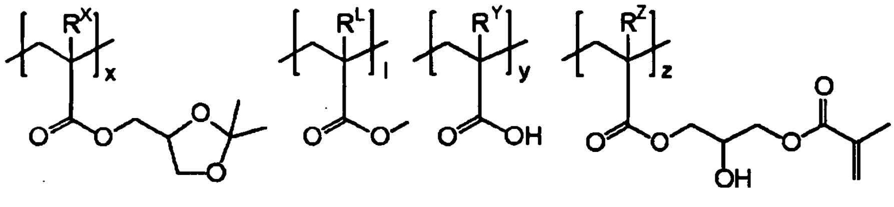

P-17

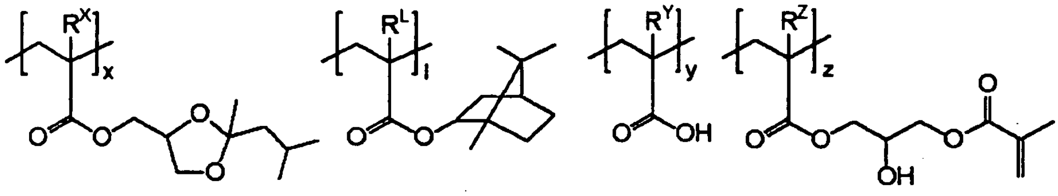

P-18

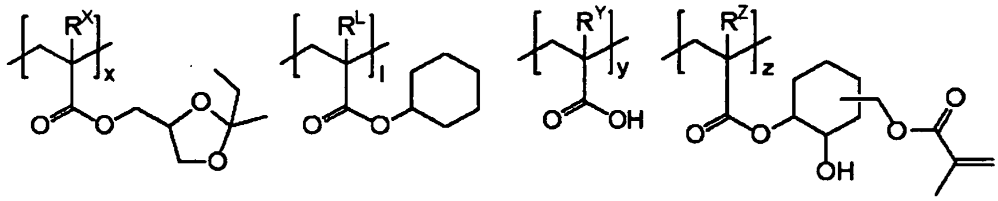

P-19

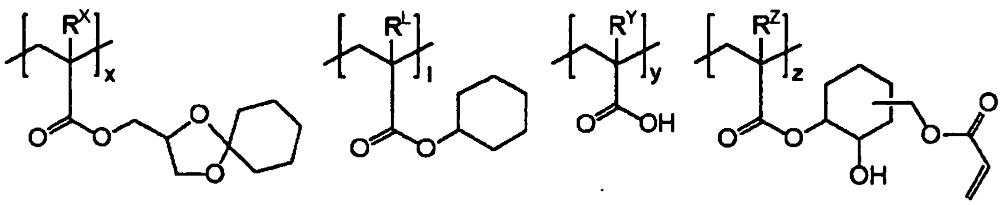

P-20

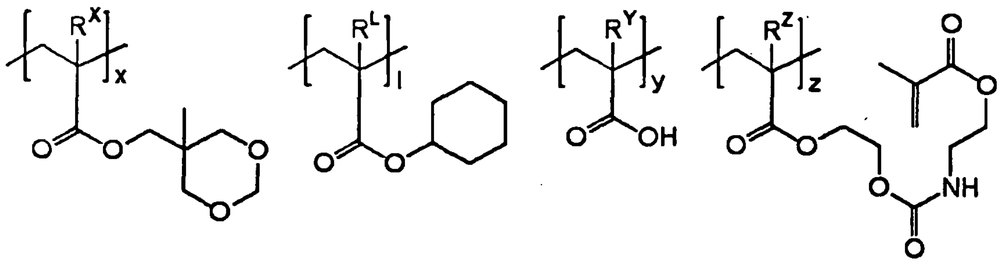

P-21

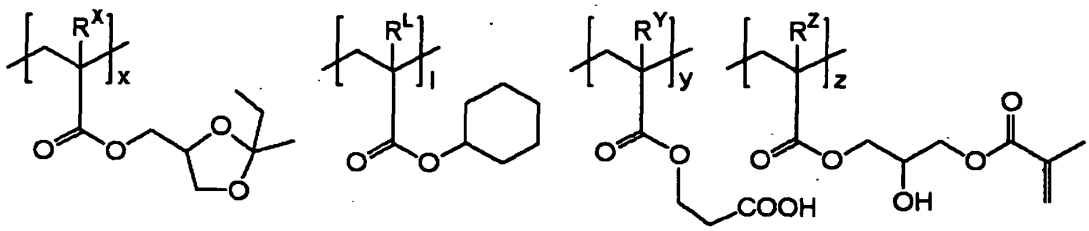

P-22

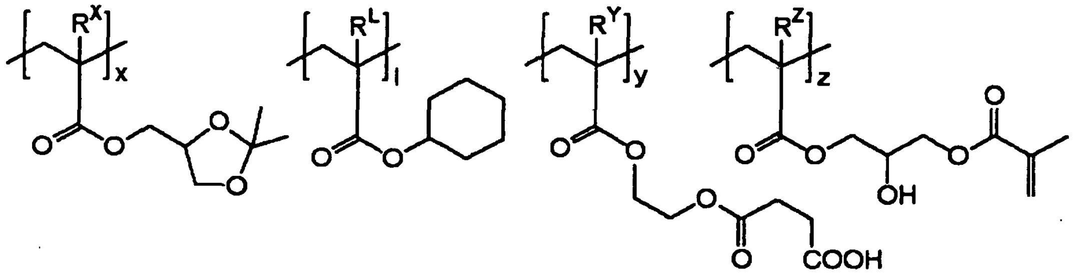

P-23

Production Method

The resin (A) is produced by a two-stage process involving a process of (co)polymerization reaction of monomers, and a process of introducing an ethylenically unsaturated group to the monomer.

First, examples of the (co)polymerization reaction include various (co)polymerization reactions of various monomers, and the (co)polymerization reaction may be appropriately selected from known (co)polymerization reactions without particular limitation. For example, with respect to the active species of the polymerization, radical polymerization, cationic polymerization, anionic polymerization, coordination polymerization, and the like may be appropriately selected. Of these, radical polymerization is preferred in view of easiness in synthesis and low costs. The method of the polymerization is not particularly limited, and may be appropriately selected from known methods. Examples of the polymerization method include bulk polymerization, suspension polymerization, emulsion polymerization, and solution polymerization. Of these methods, solution polymerization is more preferable.

Molecular weight

The weight-average molecular weight of the copolymer favorably selected as the resin (A) is preferably from 10,000 to 100,000, more preferably from 12,000 to 60,000, and even more preferably from 15,000 to 45,000. It is preferable that the weight-average molecular weight is within this range from the viewpoints of the suitability for production of the copolymer and developability. Moreover, it is preferable that the weight-average molecular weight is within this range because, due to a reduction in the melt viscosity, the shape formed from the composition does not easily collapse, poor crosslinkage hardly occurs, and spacer-shaped residues do not remain after development.

Glass transition temperature

The glass transition temperature (Tg) of the resin (A) is preferably from 10 to 180°C, more preferably from 10 to 140°C, and particularly preferably from 20 to 130°C. When the glass transition temperature (Tg) is within this range, a photospacer which has excellent mechanical strength and which enables excellent developability may be obtained.

Acid value

A preferred range of the acid value of the resin (A) is varied in accordance with the molecular structure thereof. In general, the acid value is preferably 20 mg KOH/g or more, more preferably 30 mg KOH/g or more, and particularly preferably from 45 to 105 mg KOH/g. When the acid value is within this range, a photospacer which has excellent mechanical strength and which enables excellent developability may be obtained.

In view of obtaining a photospacer having excellent mechanical strength and which enables excellent developability, it is preferred that the glass transition temperature (Tg) of the resin (A) is from 40 to 180°C and the weight-average molecular weight thereof is from 10,000 to 100,000.

A preferable example of the resin (A) is a resin that combines the preferred ranges of the molecular weight, the glass transition temperature (Tg) and the acid value.

The resin (A) in the invention is preferably a ternary or higher copolymer wherein one copolymer unit has a group X (x% by mole) having a cyclic structure including two or more heteroatoms in a side chain, one copolymer unit has a group Y (y% by mole) having an acidic group in a side chain, and one copolymer unit has a group Z (z% by mole) having an ethylenically unsaturated group in a side chain, from the viewpoints of the deformation restoration ratio, development residue, and reticulation. Specifically, the resin (A) is preferably a copolymer obtained by copolymerizing at least one monomer having X, at least one monomer having Y, and at least one monomer having Z.

The copolymerization composition ratio between the respective components of the resin (A) is not necessarily specified since the ratio is decided in consideration of the glass transition temperature and the acid value. The copolymerization composition ratio (x) of the group having a cyclic structure including two or more heteroatoms in a side chain is preferably from 10 to 70% by mole, more preferably from 15 to 65% by mole, and particularly preferably from 20 to 60% by mole. When the copolymerization composition ratio (x) of the group having two or more cyclic structures in a side chain is within this range, excellent developability is obtained and the resistance of the image regions to a developing solution is also excellent.

The copolymerization composition ratio (y) of the group having an acidic group in a side chain is preferably from 5 to 70% by mole, more preferably from 10 to 60% by mole, and particularly preferably from 20 to 50% by mole. When the copolymerization composition ratio (y) of the group having an acidic group in a side chain is within this range, excellent curability and excellent developability may be obtained.

The copolymerization composition ratio (z) of the group having an ethylenically unsaturated group in a side chain is preferably from 10 to 70% by mole, more preferably from 20 to 70% by mole, and particularly preferably from 30 to 70% by mole. When the copolymerization composition ratio (z) of the group having an ethylenically unsaturated group in a side chain is within this range, pigment dispersibility is excellent and, further, the developability and the curability are also excellent.

When the resin (A) includes an additional group (L), the copolymerization composition ratio (1) of the additional group is preferably from 0 to 30% by mole, and more preferably from 0 to 20% by mole.

The amount of the resin (A) is preferably from 5 to 70% by mass, and more preferably from 10 to 50% by mass, of the total solid content of the photosensitive composition. The resin (A) may include an other additional resin as shown below. However, the resin (A) preferably does not include the additional resin.

Additional resin

An example of the resin which may be used together with the resin (A) is preferably a compound exhibiting swellability in an aqueous alkaline solution, more preferably a compound that is soluble in an aqueous alkaline solution.

A preferred example of the resin that is swellable or soluble in an aqueous alkaline solution is a resin having an acidic group. Specific preferred examples thereof include: compounds wherein an ethylenically unsaturated double bond and an acidic group are introduced into an epoxy compound (epoxy acrylate compounds); vinyl copolymers having, in their side chain, a (meth)acryloyl group and an acidic group; mixtures each composed of an epoxy acrylate compound and a vinyl copolymer having, in a side chain, a (meth)acryloyl group and an acidic group; and maleamide acid copolymers.

The acidic group is not particularly limited, and may be appropriately selected in accordance with a purpose. Examples of the acidic group include a carboxylic group, a sulfonic acid group, and a phosphoric acid group. Of these examples, preferred is a carboxyl group from the viewpoint of availability of the starting material, and the like.

Ratio of resin (A) and different resin

The total amount (solid content) of the resin (A) and the resin which may be used together with the resin (A) is preferably from 5 to 70% by mass, or more preferably from 10 to 50% by mass of the total solid content in the photosensitive composition. When the amount is less than 5% by mass, the film strength of the photosensitive layer, which will be described later, tends to be weak and the surface tackiness of the photosensitive layer may deteriorate.

When the amount is more than 70% by mass, the exposure sensitivity may decrease. The amount means a solid content of the resins.

Polymerizable compound (B), photopolymerization initiator (C), and other components

In the invention, the polymerizable compound (B), the photopolymerization initiator (C), and other components may be selected from those used in a known composition. Examples thereof include components described in paragraphs [0010] to [0020] in JP-A No. 2006-23696, and components described in paragraphs [0027] to [0053] in JP-A No. 2006-64921.

Regarding the relationship between the resin (A) and the component (B), the ratio by mass of the polymerizable compound (B) to the resin (A) (the ratio (B)/(A)) is preferably form 0.5 to 2.0, more preferably from 0.6 to 1.4, particularly preferably from 0.7 to 1.2. When the ratio (B)/(A) is in the range, a photospacer which has excellent mechanical strength and which enables excellent developability may be obtained.

The amount of the photopolymerization initiator (C) is preferably from 0.1 to 20% by mass, or more preferably from 0.5 to 10 % by mass with respect to the resin (A).

The photopolymerization initiator (C) in the invention may be, for example, the following photopolymerization initiator or photopolymerization initiator system:

vicinal polyketaldonyl compounds disclosed in US Patent No. 2367660, acyloin ether compounds disclosed in US Patent No. 2448828, aromatic acyloin compounds having a substituent at their $\alpha$-hydrocarbon, which are disclosed in US Patent No. 2722512, polynuclear quinone compounds disclosed in US Patent Nos. 3046127 and 2951758, a combination of a triarylimidazole dimer with p-aminoketone disclosed in US Patent No. 3549367, benzothiazole compounds and trihalomethyl-s-triazine compounds described in Japanese Patent Application Publication (JP-B) No. 51-48516, trihalomethyl-triazine compounds disclosed in US Patent No. 4239850, and trihalomethyloxadiazole compounds described in US Patent No. 4212976. Particularly preferred are trihalomethyl-s-triazine compounds, trihalomethyloxadiazole compounds, and a triarylimidazole dimer.

Besides, a "polymerization initiator C" disclosed in JP-A No. 11-133600 may be also a preferred example.

One of the photopolymerization initiators and photopolymerization initiator systems may be used, or two or more thereof may be used in combination. It is particularly preferred to use two or more of the initiators and the systems; in this case, display defects, in particular, display unevenness may be suppressed.

The amount of the photopolymerization initiator or the photopolymerization initiator system with respect to the total solid content in the photosensitive composition is generally from 0.5 to 20% by mass, preferably from 1 to 15% by mass.

The following initiator may also be preferably used:

an aminoacetophenone initiator, examples of which include IRGACURE (Irg) 369, IRGACURE (Irg) 379, and IRGACURE (Irg) 907 (trade names, all manufactured by Ciba Specialty Chemicals Inc.);
an acylphosphine oxide initiator, examples of which include DAROCUR TPO, and IRGACURE (Irg) 819 (trade names, all manufactured by Ciba Specialty Chemicals Inc.); and
an oxime ester initiator, examples of which include IRGACURE (Irg) OXE01, and CGI242 (trade names, all manufactured by Ciba Specialty Chemicals Inc.).

One of the photopolymerization initiator may be used, or two or more thereof may be used in combination. The amount of the photopolymerization initiator with respect to the total solid content in the photosensitive composition is generally from 0.5 to 25% by mass, preferably from 0.5 to 20% by mass. When the amount is in the range, a decrease in the photosensitivity or in the image strength may be prevented to improve the performance sufficiently.

Fine particles (D)

Preferably, fine particles are added to the photosensitive composition. The fine particles (D) are not particularly limited, and may be appropriately selected in accordance with a purpose. The fine particles (D) are preferably made of, for example, one or more out of extender pigments disclosed in paragraphs [0035] to [0041] in JP-A No. 2003-302639, in particular, colloidal silica since a photospacer having excellent mechanical strength and which enables excellent developability may be obtained.

The average particle diameter of the fine particles (D) is preferably from 5 to 50 nm, more preferably from 10 to 40 nm, particularly preferably from 15 to 30 $\mu$m since a photospacer having high mechanical strength may be obtained.

The amount of the fine particles (D), in mass ratio with respect to the total solid content in the photosensitive

composition of the invention, is preferably from 5 to 50% by mass, more preferably from 10 to 40% by mass, particularly preferably from 15 to 30% by mass.

(E) Photopolymerization initiation aid

In the photosensitive composition of the invention, at least one photopolymerization initiation aid (E) may be used.

The photopolymerization initiation aid (E) is used in combination with the photopolymerization initiator (C), and is a compound that is used to promote polymerization of the photopolymerizable compound initiated by the photopolymerization initiator. The photopolymerization initiation aid may include at least one amine compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone, which is commonly called as Michler's ketone, 4,4'-bis(diethylamino)benzophenone, and 4,4'-bis(ethylmethylamino) benzophenone. Of the compounds, 4,4'-bis(diethylamino)benzophenone is preferred. Such amine compounds may be used in combination of two or more thereof, or such an amine compound may be used in combination with another photopolymerization initiation aid. Examples of the another photopolymerization initiation aid include an alkoxyanthracene compound, a thioxanthone compound, and a coumarine compound.

Examples of the alkoxyanthracene compound include 9,10-dimethoxyanthracene, 2-ethyl-9,10-dimethoxyanthracene, 9,10-diethoxyanthracene, and 2-ethyl-9,10-diethoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

The photopolymerization initiation aid may be a commercially available product. An example of the commercially available photopolymerization initiation aid is "EAB-F" (trade name) manufactured by Hodogaya Chemical Co., Ltd.

The use amount of the photopolymerization initiation aid (E) in the photosensitive composition of the invention is preferably from 0.6 parts by mass to 20 parts by mass, more preferably from 1 part by mass to 15 parts by mass, even more preferably from 1.5 parts by mass to 15 parts by mass per 1 part by mass of the photopolymerization initiator (C).

Patterning process

The patterning process in the invention includes exposing and developing a photosensitive resin layer formed on a support so as to pattern the layer. Specific preferred examples of the patterning process include: the process in the formation example described in paragraphs [0071] to [0077] of JP-A No. 2006-64921; and the process described in paragraphs [0040] to [0051] of JP-A No. 2006-23696.

The photospacer of the invention may be formed after a color filter including a black shielding region such as a black matrix and a colored region such as a colored pixel, has been formed.

The black shielding region, the colored region, and the photospacer may be formed by any given combination of an application method of applying the photosensitive composition and a transfer method using a transfer material having a photosensitive resin layer made from the photosensitive composition.

The black shielding region, the colored region, and the photospacer may each be formed from the photosensitive composition. Specifically, for example, the photosensitive composition in liquid form is applied directly onto a substrate to form a photosensitive resin layer, and then the layer is exposed to light and developed to form the black shielding region and the colored region patternwise. Thereafter, another liquid including the photosensitive composition is applied onto another substrate (pre-support) different from the above-mentioned substrate to form a photosensitive resin layer, thereby producing a transfer material. The transfer material is adhered closely to the substrate on which the black shielding region and the colored region are formed, so as to transfer the photosensitive resin layer. Thereafter, the resultant layer is exposed to light and then developed, whereby photospacers may be formed patternwise. In such a way, a color filter on which photospacers are provided may be produced.

Liquid Crystal Display Device Substrate

The liquid crystal display device substrate (i.e., the substrate for a liquid crystal display device) of the invention may include a photospacer produced by the photospacer producing method of the invention. The photospacer is preferably formed on a light shielding region for display, such as a black matrix, formed on a support or on a driving element such as TFT. A transparent electroconductive layer (transparent electrodes) made of ITO or the like or a liquid crystal orientation film made of polyimide or the like may be present between the light shielding region for display, such as a black matrix, and a photospacer or between the driving element, such as TFT, and a photospacer.

For example, when the photospacer is formed on the light shielding region for display or on the driving element,

the liquid crystal display device substrate of the invention may be produced by: laminating, for example, the photosensitive resin layer of a photosensitive resin transfer film onto the surface of the support to cover the light shielding region for display (such as a black matrix) or the driving element which have been arranged on the support; peeling the film to transfer the photosensitive resin layer onto the support, thereby forming a photosensitive resin layer on the support; and subjecting the resultant to light exposure, development, a heating treatment or the like, thereby forming a photospacer.

The liquid crystal display device substrate of the invention may further have colored pixels in, for example, three colors of red (R), blue (B) and green (G), if required.

Liquid Crystal Display Element

A liquid crystal display element may be constructed by using the liquid crystal display device substrate of the invention. An example of the liquid crystal display element is a display element having at least a liquid crystal layer and a liquid crystal driving unit, which may be in a passive matrix driving manner or an active matrix driving manner, between a pair of supports at least one of which is light transmissible (and includes the liquid crystal display device substrate of the invention).

In this case, the liquid crystal display device substrate of the invention may be constructed as a color filter substrate having RGB pixel groups wherein individual pixels which constitute the pixel groups are separated from each other by means of a black matrix. In this color filter substrate, the photospacer, which has uniform height and excellent deformation restorability, is arranged. Therefore, in a liquid crystal display element having the color filter substrate, the generation of a cell gap unevenness (fluctuation in the cell thickness) between the color filter substrate and an opposing substrate is prevented, and the display unevenness such as color unevenness may effectively prevented. In this way, vivid images may be displayed in the thus-produced liquid crystal display element.

Another exemplary embodiment of the liquid crystal display element includes at least a liquid crystal layer and a liquid crystal driving unit between a pair of supports at least one of which is light transmissible (and includes the liquid crystal display device substrate of the invention), wherein the liquid crystal driving unit has an active element (for example, a TFT) and the distance between the pair of supports is regulated to be a predetermined distance by the photospacer which has uniform height and excellent deformation restorability.

In this case also, the liquid crystal display device substrate of the invention is constructed as a color filter substrate having RGB pixel groups wherein individual pixels which constitute the pixel groups are separated from each other by means of a black matrix.

Examples of the liquid crystal which may be used in the invention include nematic liquid crystals, cholesteric liquid crystals, smectic liquid crystals, and ferroelectric liquid crystal.

The pixel groups of the color filter substrate may be composed of pixels of two different colors, three different colors, or four or more different colors. When using, for example, three-color pixel groups, the colors used may be red (R), green (G) and blue (B). When pixel groups of the three colors of RGB are arranged, the groups are preferably arranged into a mosaic form, a triangular form, or the like. When pixel groups of four or more colors are arranged, the groups may be arranged into any form. In the production of the color filter substrate, for example, pixel groups of two or more colors may be formed, followed by formation of a black matrix as described above or, conversely, pixel groups may be formed after a black matrix has been formed. Regarding the formation of RGB pixels, JP-A No. 2004-347831 or the like may be used as a reference.

Liquid Crystal Display Device

The liquid crystal display device of the invention may include the above-mentioned liquid crystal display device substrate. Alternatively, the liquid crystal display device of the invention may include the above-mentioned liquid crystal display element. Specifically, in the device, the distance between a pair of substrates arranged so as to be opposite to each other is regulated into a predetermined distance by means of a photospacer produced by the photospacer producing method of the invention, as described above, and a liquid crystal material is enclosed in the regulated gap (the region where the liquid crystal material is enclosed is called a liquid crystal layer), whereby the thickness of the liquid crystal layer (the cell thickness) is kept at a desired uniform thickness.

Preferred examples of the liquid crystal display mode of the liquid crystal display device include STN, TN, GH, ECB, ferroelectric liquid crystal, antiferroelectric liquid crystal, VA, IPS, OCB and ASM modes, and other various modes. In particular, from the viewpoint of attaining the advantageous effects of the invention most effectively in the liquid crystal display device of the invention, a display mode wherein display unevenness is easily caused by a fluctuation in the cell thickness of a liquid crystal cell is preferred, the liquid crystal display device is preferably made into a structure in a VA, IPS or OCB display mode wherein the cell thickness is from 2 to 4 $\mu$m.

Examples of embodiments of the basic configuration of the liquid crystal display device of the invention include: a structure (a) wherein: a driving side substrate at which driving elements, such as thin film transistors (TFTs) and pixel

electrodes (electroconductive layer) are formed and arrayed, and an opposing substrate having opposing electrodes (electroconductive layer) are arranged so as to oppose to each other with a photospacer interposed therebetween; and a liquid crystal material is enclosed in the gap between the substrates; and a structure (b) wherein: a driving substrate and an opposing substrate having opposing electrodes (electroconductive layer) are arranged so as to oppose to each other with a photospacer interposed therebetween; and a liquid crystal material is enclosed in the gap between the substrates. The liquid crystal display device of the invention may be preferably applied to various liquid crystal display apparatuses.

For example, Next-Generation Liquid Crystal Display Techniques (Tatsuo Uchida, ed., Kogyo Chosakai Publishing, Inc.: 1994) describes liquid crystal display devices. The liquid crystal display device of the invention is not particularly limited as long as the device has the liquid crystal display element of the invention. The liquid crystal display device of the invention may be incorporated into liquid crystal display devices in various manners as described in *Next-Generation Liquid Crystal Display Techniques*. The invention is particularly effective for constructing a color TFT liquid crystal display device. Color TFT liquid crystal display devices are described in, for example, Color TFT Liquid Crystal Displays (Kyoritsu Shuppan Co., Ltd.: 1996).

The liquid crystal display device of the invention may generally be configured using various members such as an electrode substrate, a polarizing film, a retardation film, a backlight, a spacer, a viewing angle compensation film, an antireflection film, a light diffusion film, and an antiglare film, as long as the device includes the liquid crystal display element of the invention. These members are described in, for example, The '94 Market for Liquid Crystal Display Peripheral Materials/Chemicals (Kentaroh Shima, CMC Publishing Co., Ltd.: 1994) and The Current Situation and Prospects for Liquid Crystal-Related Markets in 2003 (Second volume) (Ryohkichi Omote, Fuji Chimera Research Institute, Inc.: 2003).

Hereinafter, exemplary embodiments of the present invention are described.

(1) A photosensitive composition, comprising:

a resin (A) including a group having a cyclic structure including two or more heteroatoms in a side chain as defined above, a group having an acidic group in a side chain, and a group having an ethylenically unsaturated group in a side chain;
a polymerizable compound (B); and
a photopolymerization initiator (C).

(2) The photosensitive composition of item (1), wherein the two or more heteroatoms are each independently selected from the group consisting of an oxygen atom, a nitrogen atom, and a sulfur atom.
(3) The photosensitive composition of item (1), wherein the weight-average molecular weight of the resin (A) is from 10,000 to 100,000.
(4) The photosensitive composition of item (1), wherein the ratio by mass of the polymerizable compound (B) to the resin (A) ((B)/(A)) is from 0.5 to 2.
(5) The photosensitive composition of item (1), further comprising fine particles (D).
(6) The photosensitive composition of item (5), wherein the average particle diameter of the fine particles (D) is from 5 to 50 nm, and
the content of the fine particles (D) with respect to the total solid content in the photosensitive composition is from 5 to 50% by mass.
(7) The photosensitive composition of item (5), wherein the fine particles (D) are particles of colloidal silica.
(8) A photosensitive resin transfer film, comprising:

a pre-support; and
a photosensitive resin layer provided on the pre-support,
wherein the photosensitive resin layer is formed using the photosensitive composition of item (1).

(9) The photosensitive resin transfer film of item (8), further comprising at least one of an oxygen blocking layer and a thermoplastic resin layer between the photosensitive resin layer and the pre-support.
(10) A method for producing a photospacer, comprising applying the photosensitive composition of item (1) to form a photosensitive resin layer on a support.
(11) A method for producing a photospacer, comprising transferring the photosensitive resin transfer film of item (8) by means of at least one of heating and pressing to form a photosensitive resin layer on a support.
(12) A substrate for a liquid crystal display device, comprising a photospacer produced by the method for producing a photospacer of item (10).
(13) A liquid crystal display device, comprising the substrate for a liquid crystal display device of item (12).

EXAMPLES

The present invention will be more specifically described by way of the following examples. However, the invention is not limited to the examples unless otherwise deviated from the statement. Unless otherwise specified, the units "%" and "part(s)" mean "% by mass" and "part(s) by mass", respectively.

Synthesis of a resin (A) represented by Compound Structure P-1 will be described in the following Synthesis Example 1.

Synthesis Example 1

2.45 parts of 1-methoxy-2-propanol (trade name: MFG, manufactured by Nippon Nyukazai Co., Ltd.) is put into a reaction vessel, and then is heated to 90°C. To the reaction vessel at 90°C, a mixed solution composed of 2.07 parts of MMDOL 30 (trade name, manufactured by Osaka Organic Chemical Industry Ltd.), 1.20 parts of methacrylic acid, 0.22 part of an azo polymerization initiator (trade name: V-601, manufactured by Wako Pure Chemical Industries, Ltd.), and 2.07 parts of 1-methoxy-2-propanol is added by dropping under a nitrogen gas atmosphere over 2 hours. After the addition, the components are allowed to react, to thereby yield an acrylic resin solution.

Next, to the acrylic resin solution are added 0.0068 part of hydroquinone monomethyl ether and 0.02 part of tetraethylammonium bromide, and then 1.23 parts of glycidyl methacrylate is added by dropping thereto over 2 hours. After the addition by dropping, the components are allowed to react at 90°C for 4 hours while air is blown into the vessel. Thereafter, a solvent is added thereto so as to adjust the concentration of solid contents to be 45%, to thereby yield a solution of a resin represented by Compound Structure P-1 having an unsaturated group (45% solution in 1-methoxy-2-propanol, acid value of solid content: 65.2 mg KOH/g, Mw: 10,000).

The molecular weight Mw of the resin represented by Compound Structure P-1 represents the weight-average molecular weight thereof, and the molecular weight is measured using a gel permeation chromatograph (GPC).

The resultant resin (A) specifically has a structure represented by Compound Structure P-1 wherein $R^X$ is a methyl group, $R^Y$ is a methyl group and $R^Z$ is a methyl group.

Next, syntheses of resins represented by Compound Structures P-2, P-3 and P-4 will be described in the following Synthesis Examples 2 to 4.

Synthesis Example 2

Synthesis of a resin (A) represented by Compound Structure P-2 will be described in Synthesis Example 2.

A solution of a resin represented by Compound Structure P-2 having an unsaturated group (45% solution in 1-methoxy-2-propanol, acid value of solid content: 52.1 mg KOH/g, Mw: 15,000) is yielded in the same manner as in Synthesis Example 1 except that MEDOL 30 (trade name, manufactured by Osaka Organic Chemical Industry Ltd.), methacrylic acid, and glycidyl methacrylate are added to set the ratio x:y:z in Compound Structure P-2 to be 47.5 mol%: 18.2 mol%:34.3 mol% instead of the addition of MMDOL 30, methacrylic acid and glycidyl methacrylate in Synthesis Example 1.

The resultant resin (A) specifically has a structure represented by Compound Structure P-2 wherein $R^X$ is a methyl group, $R^Y$ is a methyl group and $R^Z$ is a methyl group.

Synthesis Example 3

Synthesis of a resin (A) represented by Compound Structure P-3 will be described in Synthesis Example 3.

A solution of a resin represented by Compound Structure P-3 having an unsaturated group (45% solution in 1-methoxy-2-propanol, acid value of solid content: 58.7 mg KOH/g, Mw: 13,000) was yielded in the same manner as in Synthesis Example 1 except that MIBDOL 30 (trade name, manufactured by Osaka Organic Chemical Industry Ltd.), methacrylic acid, and glycidyl methacrylate were added to set the ratio x:y:z in Compound Structure P-3 to be 39.5 mol%:21.3 mol%:39.2 mol% instead of the addition of MMDOL 30, methacrylic acid and glycidyl methacrylate in Synthesis Example 1.

The resultant resin (A) specifically has a structure represented by Compound Structure P-3 wherein $R^X$ is a methyl group, $R^Y$ is a methyl group and $R^Z$ is a methyl group.

Synthesis Example 4 ,

Synthesis of a resin (A) represented by Compound Structure P-4 will be described in Synthesis Example 4.

A solution of a resin represented by Compound Structure P-4 having an unsaturated group (45% solution in 1-methoxy-2-propanol, acid value of solid content: 61.9 mg KOH/g, Mw: 11,000) is yielded in the same manner as in

Synthesis Example 1 except that CHDOL 30 (trade name, manufactured by Osaka Organic Chemical Industry Ltd.), methacrylic acid, and glycidyl methacrylate are added to set the ratio x:y:z in Compound Structure P-4 to be 42.4 mol%: 22.3 mol%:35.3 mol% instead of the addition of MMDOL 30, methacrylic acid and glycidyl methacrylate in Synthesis Example 1.

The resultant resin (A) specifically has a structure represented by Compound Structure P-4 wherein $R^X$ is a methyl group, $R^Y$ is a methyl group and $R^Z$ is a methyl group.

Comparative Synthesis Example 1: synthesis of alkali-soluble resin (20)

A mixed solvent composed of 25 g of 1-methoxy-2-propanol and 25 g of 1-methoxy-2-propyl acetate is put in a reaction vessel, and then is heated to 90°C. To the reaction vessel at 90°C, a mixed solution composed of 32.1 g of styrene, 36.5 g of methacrylic acid, 6.73 g of an azo polymerization initiator (trade name: V-601, manufactured by Wako Pure Chemical Industries, Ltd.), 25 g of 1-methoxy-2-propanol and 25 g of 1-methoxy-2-propyl acetate is added by dropping under a nitrogen gas atmosphere over 2 hours. After the addition by dropping, the components are allowed to react for 4 hours, to thereby yield an acrylic resin solution.

Next, to the acrylic resin solution are added 0.5 g of hydroquinone monomethyl ether and 0.015 g of tetraethylammonium bromide, and then 31.3 g of glycidyl methacrylate is added by dropping thereto over 2 hours. After the addition by dropping, the components are allowed to react at 90°C for 4 hours while air is blown into the vessel, to thereby yield an alkali-soluble resin solution. The solid content in the alkali-soluble resin (20) solution is 50%.

Example 1: transfer method

Production of photosensitive transfer film for spacer

A coating solution for a thermoplastic resin layer, which has a composition A described below, is applied onto a polyethylene terephthalate film pre-support (PET pre-support) having a thickness of 75 μm, and then dried, to thereby form a thermoplastic resin layer having a dry layer thickness of 15.0 μm.

Composition A of coating solution for thermoplastic resin layer:

| | |
|---|---|
| Methyl methacrylate/2-ethylhexyl acrylate/benzyl methacrylate/methacrylic acid copolymer (= SS/ 11.7/4.5/28.8 (molar ratio), weight-average molecular weight: 90,000): | 25 parts |
| Styrene/acrylic acid copolymer (= 63/37 (molar ratio), weight-average molecular weight: 8,000): | 58.4 parts |
| 2,2-Bis[4-(methacryloxypolyethoxy)phenyl]propane: | 39.0 parts |
| *Surfactant 1: | 10.0 parts |
| Methanol: | 90.0 parts |
| 1-Methoxy-2-propanol: | 51.0 parts |
| Methyl ethyl ketone: | 700 parts |

Next, a coating solution for an intermediate layer, which has a composition B described below, is applied onto the formed thermoplastic resin layer, and dried to laminate an intermediate layer having a dry layer thickness of 1.6 μm.

* Surfactant 1:

| | |
|---|---|
| Structure 1shown below: | 30% |
| Methyl ethyl ketone: | 70% |

Structure 1

Structure 1

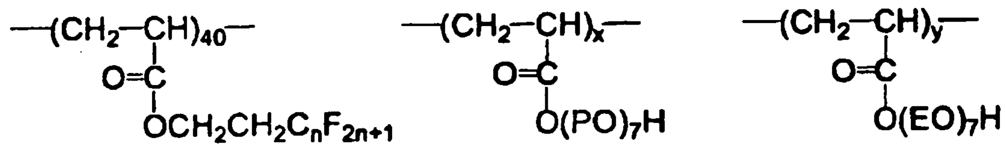

(n = 6, x = 55, y = 5; Mw = 33,940; Mw/Mn = 2.55;
PO: propylene oxide; EO: ethylene oxide)

Composition B of coating solution for intermediate layer:

| | |
|---|---|
| Polyvinyl alcohol (trade name: PVA-205 (saponification value: 88%), manufactured by Kuraray Co., Ltd.): | 3.22 parts |
| Polyvinyl pyrrolidone (trade name: PVP K-30, manufactured by ISP Japan Ltd.): | 1.49 parts |
| Methanol: | 42.3 parts |
| Distilled water: | 524 parts |

Next, a coating solution for a photosensitive resin composition layer, which has a composition 1 shown in the following Table 1, is further applied onto the formed intermediate layer, and dried to laminate a photosensitive resin composition layer having a dry layer thickness of 4.1 μm.

As described above, a laminate structure of the PET pre-support/the thermoplastic resin layer/the intermediate layer/the photosensitive resin composition layer is formed, and then, as a cover film, a polypropylene film having a thickness of 12 μm is further adhered onto the surface of the photosensitive resin composition layer by heating and pressing, to thereby yield a photosensitive transfer film (1) for a spacer.

Formation of color filter substrate

A color filter having a black matrix and R, G and B pixels is produced by a method described in paragraphs [0084] to [0095] in JP-A No. 2005-3861. Next, transparent electrodes made of indium tin oxide (ITO) are formed by sputtering on the R, G and B pixels and the black matrix of the color filter.

Formation of photospacer

The cover film of the resultant photosensitive transfer film (1) for a spacer is peeled off. The exposed surface of the photosensitive resin composition layer is superimposed onto the ITO film of the color filter substrate on which the ITO film is formed by the sputtering, and then adhered to each other by using a laminator (trade name: LAMIC II MODEL, manufactured by Hitachi Plant Technologies, Ltd.) at a transport speed of 2 m/minute under pressing and heating conditions such that the linear pressure is 100 N/cm and the temperature is 130°C. Thereafter, the PET pre-support is peeled from the thermoplastic resin layer and removed, and the photosensitive resin composition layer together with the thermoplastic resin layer and the intermediate layer are transferred (layer forming process).

Next, a mask (quartz exposure mask having an image pattern) and the color filter substrate arranged so that the thermoplastic resin layer thereof faces the mask, are stood vertically and substantially in parallel to each other. In this state, a proximity type exposure device (manufactured by Hitachi High-Technology Electronic Corp.) equipped with a super high pressure mercury lamp is used to carry out proximity exposure from the thermoplastic resin layer side through the mask at an exposure dose of 90 mJ/cm$^2$ while the distance between the mask surface and the surface of the photosensitive resin composition layer contacting the intermediate layer is set at 100 μm.

Next, a triethanolamine developing solution (solution obtained by diluting a developing solution (trade name: T-PD2, manufactured by Fuji Photo Film Co., Ltd.) containing 30% triethanolamine 12 times with pure water (i.e., 1 part of the solution T-PD2 and 11 parts of pure water)) is used for shower development at a flat nozzle pressure of 0.04 MPa and a temperature of 30°C for 50 seconds to remove the thermoplastic resin layer and the intermediate layer. Subsequently, air is blown onto the upper surface of the glass substrate to remove the liquid. Thereafter, pure-water-shower washing is performed with pure water shower for 10 seconds, and then air is blown onto the substrate to decrease the amount of liquid remaining on the substrate.

Subsequently, an Na carbonate developing solution (including 0.38 mol/L of sodium hydrogencarbonate, 0.47 mol/L of sodium carbonate, 5% sodium dibutylnaphthalenesulfonate, an anionic surfactant, an antifoaming agent, and

a stabilizer; developing solution obtained by diluting T-CD1 (trade name, manufactured by Fuji Photo Film Co., Ltd.) 10 times with pure water) is used for shower development at a conical nozzle pressure of 0.15 MPa and a temperature of 29°C for 50 seconds, thereby yielding a pattern image for the spacers.

Subsequently, a washing agent (including a phosphate, a silicate, a nonionic surfactant, an antifoaming agent, and a stabilizer; solution obtained by diluting T-SD3 (trade name, manufactured by Fuji Photo Film Co., Ltd.) 10 times with pure water) is blown on the resultant substrate from a shower at a conical nozzle pressure of 0.02 MPa and a temperature of 33°C for 20 seconds to remove residues that exist around the formed pattern image. In this way, a desired spacer pattern is yielded.

Next, the color filter substrate on which the spacer pattern is formed is subjected to a heating treatment at 240°C for 50 minutes (heat treatment process), to thereby produce a photospacer.

The resultant spacer pattern is a pattern in the form of columns having a diameter of 24 μm and an average height of 3.6 μm. The average height is determined by observing 1000 of the resultant spacers with a three-dimensional surface structure analysis microscope (model name: NEW VIEW 5022, manufactured by ZYGO Corp.), and measuring the highest positions of the highest spacers extending from the surface on which the ITO transparent electrodes are formed (n =20).

Production of liquid crystal display device

Separately, a glass substrate is used as an opposing substrate, and then a pattern for the PVA mode is formed on each of the transparent electrodes of the color filter substrate yielded as described above and the opposing substrate. Furthermore, an orientation film made of polyimide is formed thereon, respectively.

Thereafter, a sealant including an ultraviolet curable resin is applied, by a dispenser method, onto a position corresponding to the black matrix outer frame arranged to surround the pixel groups of the color filter. A liquid crystal for the PVA mode is dripped thereon, and then the resultant structure is adhered onto the opposing substrate. Thereafter, the adhered substrates are irradiated with UV rays, and subjected to heat treatment to cure the sealant. Polarizing plates (trade name: HLC2-2518, manufactured by Sanritz Corp.) are adhered to both surfaces of the thus-obtained liquid crystal cell.

Next, red (R) LEDs (trade name: FR1112H, manufactured by Stanley Electric Co., Ltd.), green (G) LEDs (trade name: DG1112H, manufactured by Stanley Electric Co., Ltd.) and blue (B) LEDs (trade name: DB1112H, manufactured by Stanley Electric Co., Ltd.) are used to form a backlight using a side light system. The backlight is arranged at the rear surface side of the liquid crystal cell on which the polarizing plates have been arranged, to thereby produce a liquid crystal display device.

Examples 2 to 7, and Comparative Examples 1 and 2

Photospacers and liquid crystal display devices are produced in the same manner as in Example 1 except that the resin (A) is changed from Compound Structure P-1 yielded in Synthesis Example 1 to the respective compound structures shown in Table 2 and the composition 1 of the coating solution for a photosensitive resin composition layer is changed to the respective compositions shown in Table 1. The resultant spacer patterns are each a pattern in the form of columns having a diameter of 24 μm and an average height of 3.6 μm.

In Table 2, the symbol "%" in the columns of "x", "y" and "z" represents "% by mole".

Example 8: Coating method

Formation of photospacer (liquid resist method)

A coating solution for a photosensitive resin composition layer, which has the composition shown in Table 1, is applied onto an ITO film of a color filter substrate on which the ITO film is formed by sputtering in the same manner as described above, by using a coater for a glass substrate (trade name: MH-1600, manufactured by F.A.S Asia Co. [*transliteration*]) having a slit-form nozzle. Subsequently, a vacuum-drying machine (trade name: VCD, manufactured by Tokyo Ohka Kogyo Co., Ltd.) is used to partially dry the solvent for 30 seconds, thereby eliminating the fluidity of the coated film. Thereafter, the resultant was pre-baked at 120°C for 3 minutes to form a photosensitive resin composition layer having a film thickness of 4.0 μm (layer forming process).

Subsequently, a photospacer is formed on the color filter substrate by the same patterning process and heat treatment process as in Example 1. However, the exposure dose is changed to 300 mJ/$cm^2$, and the conditions for the development using the KOH developing solution are changed to 23°C for 60 seconds. The resultant spacer pattern is a pattern in the form of columns having a diameter of 24 μm and an average height of 3.6 μm.

After the formation of the photospacer, the color filter substrate is used to produce a PVA mode liquid crystal

display device of the invention in the same way as in Example 1.

[Table 1]

| Coating solution for photosensitive resin composition layer | Composition 1 | Composition 6 | Composition 7 |
|---|---|---|---|
| | Examples 1-7 | Comparative Example 1 | Comparative Example 2 |
| 1-Methoxy-2-propyl acetate | 26 | 35 | 28 |
| Methyl ethyl ketone | 28 | 30 | 28 |
| Colloidal silica dispersed product (trade name: MIBKst, manufactured by Nissan Chemical Industries, Ltd.; colloidal silica: 30 parts, and methyl isobutyl ketone: 70 parts) | 14.1 | 14 | 14.1 |
| Solsperse 20000 | 0.42 | 0.42 | 0.42 |
| DPHA solution (dipentaerythritol hexaacrylate: 76 parts, and 1-methoxy-2-propyl acetate: 24 parts) | 9.1 | 9 | 9.1 |
| Solution of resin (A) (resin (A) is a compound synthesized in Synthesis Examples shown in Table 2) | 20.5 | 0 | 0 |
| Methacrylic acid/ally methacrylate copolymer (molar ratio =20/80, weight-average molecular weight: 36,000) | 0 | 9.17 | 0 |
| Alkali-soluble resin (20) (solid content: 50%) | 0 | 0 | 18.4 |
| 2,4-Bis(trichloromethyl)-6-[4'-(N,N-bis (ethoxycarbonylmethyl)amino)-3'-bromophenyl]-s-triazine | 0.227 | 0.23 | 0.227 |
| Hydroquinone monomethyl ether | 0.0036 | 0.0036 | 0.0036 |
| Surfactant 1 (MEGAFAC F-780-F, manufactured by Dainippon Ink & Chemicals, Inc.) | 0.032 | 0.03 | 0.032 |
| 5% Solution of Victoria Pure Blue NAPS (manufactured by Hodogaya Chemical Co., Ltd.) in methanol | 2.05 | 2.04 | 2.05 |
| Unit: part(s) by mass | | | |

[Table 2]

| | Resin (A) | | | | | | | | | Fine particles (D) | | | Evaluation | | | | |
|---|---|---|---|---|---|---|---|---|---|---|---|---|---|---|---|---|---|
| | Synthesis Example | Compound structure | Weight-average molecular weight | Acid value mg KOH/g | X: unit | x | y | z | B/A | Species | Average particle diameter (nm) | Formation method | Deformation restoration ratio (%) | Developability | Laminate suitability | Reticulation | Display unevenness |
| Example 1 | 1 | P-1 | 10,000 | 65.2 | MMDOL30 | 42.6% | 21.6% | 35.8% | 0.9 | Colloidal silica | 15 | Transfer | 5 | 4 | 3 | 4 | A |
| Example 2 | 2 | P-2 | 15,000 | 52.1 | MEDOL30 | 47.5% | 18.2% | 34.3% | 0.9 | Colloidal silica | 15 | Transfer | 4 | 4 | 3 | 4 | A |
| Example 3 | 3 | P-3 | 13,000 | 58.7 | MIBDOL30 | 39.5% | 21.3% | 39.2% | 0.9 | Colloidal silica | 15 | Transfer | 5 | 4 | 3 | 4 | A |
| Example 4 | 4 | P-4 | 11,000 | 61.9 | CHDOL30 | 42.4% | 22.3% | 35.3% | 0.9 | Colloidal silica | 15 | Transfer | 4 | 4 | 3 | 4 | A |
| Example 5 | 1 | P-1 | 10,000 | 65.2 | MMDOL30 | 42.6% | 21.6% | 35.8% | 0.5 | Colloidal silica | 15 | Transfer | 5 | 4 | 3 | 4 | A |
| Example 6 | 1 | P-1 | 10,000 | 65.2 | MMDOL30 | 42.6% | 21.6% | 35.8% | 1.5 | Colloidal silica | 15 | Transfer | 5 | 4 | 2-3 | 3 | A |
| Example 7 | 1 | P-1 | 10,000 | 65.2 | MMDOL30 | 42.6% | 21.6% | 35.8% | 0.75 | Colloidal silica | 15 | Transfer | 5 | 4 | 3 | 5 | A |
| Example 8 | 1 | P-1 | 10,000 | 65.2 | MMDOL30 | 42.6% | 21.6% | 35.8% | 2.0 | Colloidal silica | 15 | Liquid resist | 5 | 4 | - | - | A |
| Comparative Example 1 | - | - | 36,000 | 95 | - | - | - | - | 0.75 | Colloidal silica | 15 | Transfer | 1 | 4 | 3 | 3 | C |
| Comparative Example 2 | 20 | 20 | 8,000 | 100 | (Styrene) | (32%) | 45% | 23% | 0.75 | Colloidal silica | 15 | Transfer | 2 | 4 | 3 | 3 | C |

Evaluation

Deformation restoration ratio

A micro hardness tester (trade name: DUH-W201, manufactured by Shimadzu Corp.) is used for measurement and evaluation of each of the photospacers as follows. In the measurement, a circular truncated cone indenter (frustum indenter) having a diameter of 50 μmϕ is used. When each of the photospacers has a diameter of 24 μm, the measurement is performed by a loading-unloading test method under conditions in which the largest load is set at 50 mN and the load-holding time is set at 5 seconds. From the measured value, the deformation restoration ratio (%) is calculated in accordance with the following equation. In accordance with the following criterion, the photospacer is evaluated. The measurement is performed at a temperature of 22 ± 1°C and a relative humidity of 50%.

**Deformation restoration ratio (%) = (restoration amount (μm) after the load is removed/deformation amount (μm) due to the load) × 100**

Evaluation criterion

5: The deformation restoration ratio is 90% or more.
4: The deformation restoration ratio is 87% or more and less than 90%.
3: The deformation restoration ratio is 85% or more and less than 87%.
2: The deformation restoration ratio is 80% or more and less than 85%.
1: The deformation restoration ratio is 75% or more and less than 80%.
0: The deformation restoration ratio is less than 75%.

Developability

In the "Formation of a photospacer" section, each of the workpieces is subjected to proximity exposure, developed under the same conditions as in each of Examples, and the periphery of the formed photospacer is observed with an SEM to confirm whether or not residues are left in the periphery.

Evaluation criterion

5: Residues are not observed at all.
4: Slight residues are observed in the periphery of the pattern.
3: Residues are observed in the periphery of the pattern.
2: Residues are observed in the periphery of the pattern and on the substrate near the pattern.
1: Residues are observed in a number of places on the substrate.

Laminate suitability (lamination foam) evaluation

In the state in which each of the color filter substrates is transferred to the photosensitive resin transfer film, the pre-support is peeled, and then the laminate state is observed with an optical microscope to confirm whether or not lamination foam is present.

Evaluation criterion

3: Lamination foam is not present at all.
2: Lamination foam is generated in a region other than the pattern region.
1: Lamination foam is generated in the pattern region.

Reticulation

Each of the photosensitive resin transfer films is allowed to stand still at a temperature of 45°C and a relative humidity of 75% for 24 hours, and then the surface of the film is observed with a microscope. The film is visually evaluated in accordance with the following criterion.

Evaluation criterion

4: Fine "wrinkles" or the like are not observed at all.
3: Fine "wrinkles" or the like are observed in very slight quantity, but the film is acceptable for practical use.
2: Fine "wrinkles" or the like are observed in small quantity.
1: Fine "wrinkles" or the like are observed in considerable quantity.

Display unevenness

Gray test signals are input to each of the liquid crystal display devices. The gray display is observed visually and also using a magnifying lens. The presence or absence of display unevenness is evaluated in accordance with the following criterion.

Evaluation criterion

A: Display unevenness is not observed at all.
B: Slight display unevenness is observed.
C: Considerable display unevenness is observed.

## Claims

**1.** A photosensitive composition, comprising:

a resin (A) including a group having a cyclic structure including two or more heteroatoms in a side chain, a group having an acidic group in a side chain, and a group having an ethylenically unsaturated group in a side chain;
a polymerizable compound (B); and
a photopolymerization initiator (C),
wherein the group having a cyclic structure including two or more heteroatoms in a side chain has a structure represented by the following Formula (a):

Formula (a)

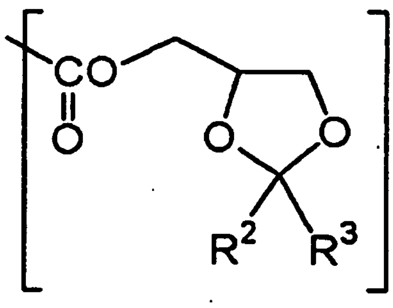

wherein, in Formula (a), $R^2$ and $R^3$ each independently represent a hydrogen atom, a methyl group, an ethyl group, an n-propyl group, an n-butyl group, or a branched alkyl group having 3 to 12 carbon atoms; and $R^2$ and

$R^3$ may be bonded to each other to form a ring.

**2.** The photosensitive composition of claim 1, wherein the weight-average molecular weight of the resin (A) is from 10,000 to 100,000.

**3.** The photosensitive composition of claim 1, wherein the ratio by mass of the polymerizable compound (B) to the resin (A) ((B)/(A)) is from 0.5 to 2.

**4.** The photosensitive composition of claim 1, further comprising fine particles (D).

**5.** The photosensitive composition of claim 4, wherein the average particle diameter of the fine particles (D) is from 5 to 50 nm, and
the content of the fine particles (D) with respect to the total solid content in the photosensitive composition is from 5 to 50% by mass.

**6.** The photosensitive composition of claim 4, wherein the fine particles (D) are particles of colloidal silica.

**7.** A photosensitive resin transfer film, comprising:

a pre-support; and
a photosensitive resin layer provided on the pre-support, wherein the photosensitive resin layer is formed using the photosensitive composition of claim 1.

**8.** The photosensitive resin transfer film of claim 7, further comprising at least one of an oxygen blocking layer and a thermoplastic resin layer between the photosensitive resin layer and the pre-support.

**9.** A method for producing a photospacer, comprising applying the photosensitive composition of claim 1 to form a photosensitive resin layer on a support.

**10.** A method for producing a photospacer, comprising transferring the photosensitive resin transfer film of claim 7 by means of at least one of heating and pressing to form a photosensitive resin layer on a support.

**11.** A substrate for a liquid crystal display device, comprising a photospacer produced by the method for producing a photospacer of claim 9.

**12.** A liquid crystal display device, comprising the substrate for a liquid crystal display device of claim 11.

## Patentansprüche

**1.** Lichtempfindliche Zusammensetzung, umfassend:

ein Harz (A), umfassend eine Gruppe mit einer cyclischen Struktur, umfassend zwei oder mehrere Heteroatome in einer Seitenkette, eine Gruppe mit einer sauren Gruppe in einer Seitenkette und eine Gruppe mit einer ethylenisch ungesättigten Gruppe in einer Seitenkette;
eine polymerisierbare Verbindung (B); und
einen Photopolymerisationsinitiator (C),
worin die Gruppe mit einer cyclischen Struktur, umfassend zwei oder mehrere Heteroatome in einer Seitenkette, eine Struktur hat, dargestellt durch die folgende Formel (a):

Formel (a)

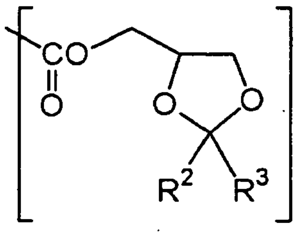

worin in der Formel (a) $R^2$ und $R^3$ jeweils unabhängig ein Wasserstoffatom, eine Methyl-, Ethyl-, n-Propyl-, n-Butyl- oder verzweigte Alkylgruppe mit 3 bis 12 Kohlenstoffatomen sind; und $R^2$ und $R^3$ aneinander zur Bildung eines Ringes gebunden sein können.

**2.** Lichtempfindliche Zusammensetzung nach Anspruch 1, worin das Molekulargewicht im Gewichtsmittel des Harzes (A) von 10.000 bis 100.000 ist.

**3.** Lichtempfindliche Zusammensetzung nach Anspruch 1, worin das Massenverhältnis der polymerisierbaren Verbindung (B) zum Harz (A) ((B)/(A)) von 0,5 bis 2 ist.

**4.** Lichtempfindliche Zusammensetzung nach Anspruch 1, weiterhin umfassend feine Teilchen (D).

**5.** Lichtempfindliche Zusammensetzung nach Anspruch 4, worin der durchschnittliche Teilchendurchmesser der feinen Teilchen (D) von 5 bis 50 nm ist und der Gehalt der feinen Teilchen (D) in Bezug auf den Gesamtfeststoffgehalt in der lichtempfindlichen Zusammensetzung von 5 bis 50 Massen-% ist.

**6.** Lichtempfindliche Zusammensetzung nach Anspruch 4, worin die feinen Teilchen (D) Teilchen aus kolloidalem Silika sind.

**7.** Lichtempfindlicher Harztransferfilm, umfassend einen Prä-Träger; und
eine lichtempfindliche Harzschicht, die auf dem Prä-Träger vorgesehen ist, worin die lichtempfindliche Harzschicht unter Verwendung der lichtempfindlichen Zusammensetzung nach Anspruch 1 gebildet ist.

**8.** Lichtempfindlicher Harztransferfilm nach Anspruch 7, weiterhin umfassend zumindest eine von einer Sauerstoffblockierschicht und einer thermoplastischen Harzschicht zwischen der lichtempfindlichen Harzschicht und dem Prä-Träger.

**9.** Verfahren zur Erzeugung eines Photospacers, umfassend das Auftragen der lichtempfindlichen Zusammensetzung nach Anspruch 1 zur Bildung einer lichtempfindlichen Harzschicht auf einem Träger.

**10.** Verfahren zur Erzeugung eines Photospacers, umfassend das Transferieren des lichtempfindlichen Harztransferfilmes nach Anspruch 7 mit Hilfe von zumindest einem von Erwärmen und Pressen, zur Bildung einer lichtempfindlichen Harzschicht auf einem Träger.

**11.** Substrat für eine Flüssigkristallanzeigevorrichtung, umfassend einen Photospacer, erzeugt durch das Verfahren zur Erzeugung eines Photspacers nach Anspruch 9.

**12.** Flüssigkristallanzeigevorrichtung, umfassend das Substrat für eine Flüssigkristallanzeigevorrichtung nach Anspruch 11.

## Revendications

**1.** Composition photosensible, comprenant :

une résine (A) incluant un groupe ayant une structure cyclique incluant deux hétéroatomes ou plus dans une chaîne latérale, un groupe ayant un groupe acide dans une chaîne latérale, et un groupe ayant un groupe non saturé en ce qui concerne l'éthylène dans une chaîne latérale ;
un composé polymérisable (B) ; et
un initiateur de photopolymérisation (C),
dans laquelle le groupe ayant une structure cyclique incluant deux hétéroatomes ou plus dans une chaîne latérale a une structure représentée par la Formule (a) suivante:

Formule (a)

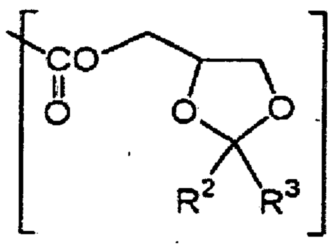

dans laquelle, dans la Formule (a), $R^2$ et $R^3$ représentent chacun indépendamment un atome d'hydrogène, un groupe méthyle, un groupe éthyle, un groupe n-propyle, un groupe n-butyle, ou un groupe alkyle ramifié ayant 3 à 12 atomes de carbone ; et $R^2$ et $R^3$ peuvent être liés l'un à l'autre pour former un anneau.

**2.** Composition photosensible selon la revendication 1, dans lequel la masse moléculaire moyenne en poids de la résine (A) est de 10 000 à 100 000.

**3.** Composition photosensible selon la revendication 1, dans laquelle le rapport en masse du composé polymérisable (B) sur la résine (A) ((B) / (A)) est de 0,5 à 2.

**4.** Composition photosensible selon la revendication 1, comprenant en outre des particules fines (D).

**5.** Composition photosensible selon la revendication 4, dans laquelle le diamètre de particule moyen des particules fines (D) est de 5 à 50 nm, et
la teneur des particules fines (D) par rapport à la teneur totale en solides dans la composition photosensible est de 5 à 50 % en masse.

**6.** Composition photosensible selon la revendication 4, dans laquelle les particules fines (D) sont des particules de silice colloïdale.

**7.** Film de transfert à résine photosensible, comprenant :

un pré-support ; et
une couche de résine photosensible disposée sur le pré-support, dans lequel la couche de résine photosensible est formée en utilisant la composition photosensible de la revendication 1.

**8.** Film de transfert à résine photosensible selon la revendication 7, comprenant en outre au moins l'une d'une couche de blocage d'oxygène et d'une couche de résine thermoplastique entre la couche de résine photosensible et le pré-support.

**9.** Procédé pour produire un photoécarteur, comprenant l'application de la composition photosensible de la revendication 1 pour former une couche de résine photosensible sur un support.

**10.** Procédé pour produire un photoécarteur, comprenant le transfert du film de transfert à résine photosensible de la revendication 7 au moyen d'au moins l'un de chauffage et de pression pour former une couche de résine photosensible sur un support.

**11.** Substrat pour un dispositif d'affichage à cristaux liquides, comprenant un photoécarteur produit par le procédé pour produire un photoécarteur de la revendication 9.

**12.** Dispositif d'affichage à cristaux liquides, comprenant le substrat pour un dispositif d'affichage à cristaux liquides de la revendication 11.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003207787 A
- JP 2005062620 A
- JP 2002287354 A
- US 2681294 A
- JP 2004089851 A
- JP 2004017043 A
- JP 2003170098 A
- JP 2003164787 A
- JP 2003010767 A
- JP 2002079163 A
- JP 2001310147 A
- JP 7110575 A
- JP 11077942 A
- JP 2000334836 A
- JP 2002148794 A
- JP 2006023696 A
- JP 2006064921 A
- US 2367660 A
- US 2448828 A
- US 2722512 A
- US 3046127 A
- US 2951758 A
- US 3549367 A
- JP 51048516 B
- US 4239850 A
- US 4212976 A
- JP 11133600 A
- JP 2003302639 A
- JP 2004347831 A
- JP 2005003861 A


### Non-patent literature cited in the description


- Next-Generation Liquid Crystal Display Techniques. Kogyo Chosakai Publishing, Inc, 1994
- Color TFT Liquid Crystal Displays. Kyoritsu Shuppan Co., Ltd, 1996
- **Kentaroh Shima.** The '94 Market for Liquid Crystal Display Peripheral Materials/Chemicals. CMC Publishing Co., Ltd, 1994
- **Ryohkichi Omote.** The Current Situation and Prospects for Liquid Crystal-Related Markets in 2003. Fuji Chimera Research Institute, Inc, 2003